(19)

**Europäisches Patentamt**

**European Patent Office**

**Office européen des brevets**

(11)  **EP 1 724 934 A1**

(12)  **EUROPEAN PATENT APPLICATION**

(43) Date of publication:
    **22.11.2006  Bulletin 2006/47**

(51) Int Cl.:
    ***H03M 13/29*** (2006.01)      ***H03M 13/45*** (2006.01)

(21) Application number: **05255960.6**

(22) Date of filing: **26.09.2005**

(84) Designated Contracting States:
    **AT BE BG CH CY CZ DE DK EE ES FI FR GB GR HU IE IS IT LI LT LU LV MC NL PL PT RO SE SI SK TR**
    Designated Extension States:
    **AL BA HR MK YU**

(30) Priority:  **17.05.2005  JP 2005143912**

(71) Applicant: **FUJITSU LIMITED**
    **Kawasaki-shi,**
    **Kanagawa 211-8588 (JP)**

(72) Inventors:
    • **Tokita, Atsuko**
      **Kawasaki-shi,**
      **Kanagawa 211-8588 (JP)**

    • **Shirasawa, Hidetoshi**
      **Kawasaki-shi**
      **Kanagawa 211-8588 (JP)**
    • **Harata, Masakazu**
      **Kawasaki-shi**
      **Kanagawa 211-8588 (JP)**

(74) Representative: **Stebbing, Timothy Charles**
    **Haseltine Lake & Co.,**
    **Imperial House,**
    **15-19 Kingsway**
    **London WC2B 6UD (GB)**

(54)  **Method of maximum a posteriori probability decoding and decoding apparatus**

(57)  In a maximum a posteriori decoding method, when an information length N is divided by a division length L, if the number of divisions including the remainder is 2n, then backward probabilities β are calculated from the Nth backward probability in the reverse direction to the (n+1) th section and backward probabilities at division points are stored as discrete values, and in parallel with these backward probability calculations, forward probabilities α are calculated from the first forward probability in the forward direction to the nth section and the forward probabilities at division points are stored as discrete values. Subsequently, the backward probabilities and forward probabilities stored as discrete values are used to calculate backward probabilities and forward probabilities for each section, and using these probabilities, decoding results are calculated in sequence for all sections.

FIG. 6

**Description**

This invention relates to a MAP (Maximum A posteriori Probability) decoding method and a decoding apparatus using this decoding method, and more particularly relates to a MAP decoding method and apparatus in which, by simultaneously computing the backward probability and the forward probability in MAP decoding, the decoding time is shortened, and moreover the quantity of memory used is reduced.

Error correction codes correct errors contained in received and regenerated information, enabling accurate decoding into the original information, and have been applied in a variety of systems. For example, when transmitting data in mobile communications, fax transmissions and similar so as to be free of errors, or when reproducing data from such mass storage media as magnetic disks and CDs, error correction codes are used.

Among error correction codes, turbo codes (see for example U.S. Patent No. 5,446,747) have been adopted for standardization in next-generation mobile communications. Among such turbo codes, maximum a posteriori probability (MAP) decoding is prominent.

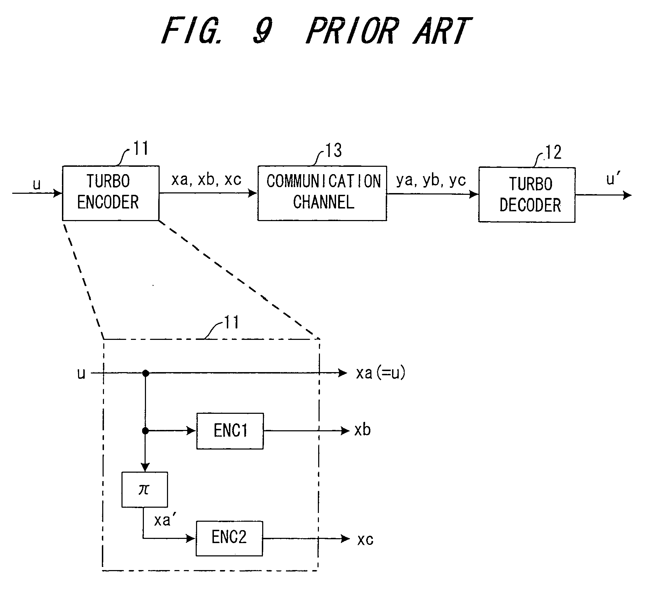

Fig. 9 shows the configuration of a communication system comprising a turbo encoder and turbo decoder; 11 is the turbo encoder provided on the data transmission side, 12 is the turbo decoder provided on the data receiving side, and 13 is the data communication channel. Further, u is transmitted information data of length N; xa, xb, xc are encoded data resulting from encoding of the information data u by the turbo encoder 11; ya, yb, yc are received signals after transmission through the communication channel 13 and with the effects of noise and fading; and u' is the result of the decoding of the received data ya, yb, yc by the turbo decoder 12. Each of these is represented as follows.

Original data:      $u = \{u1, u2, u3, ..., u_N\}$

Encoded data:    $xa = \{x_{a1}, x_{a2}, x_{a3}, ..., x_{ak}, ... , x_{aN}\}$
$xb = \{x_{b1}, x_{b2}, x_{b3}, ... , x_{bk}, ... , x_{bN}\}$
$XC = \{x_{c1}, x_{c2}, x_{c3}, ... , x_{ck}, ... , x_{cN}\}$

Received data:    $ya = \{y_{a1}, y_{a2}, y_{a3}, ..., y_{ak}, ..., y_{aN}\}$
$yb = \{y_{b1}, y_{b2}, y_{b3}, ..., y_{bk}, ..., y_{bN}\}$
$yc = \{y_{c1}, y_{c2}, y_{c3}, ..., y_{ck}, ..., y_{cN}\}$

The turbo encoder 11 encodes the information data u of information length N, and outputs the encoded data xa, xb, xc. The encoded data xa is the information data u per se, the encoded data xb is data obtained by the convolutional encoding of the information data u by an encoder ENC1, and the encoded data xc is data obtained by the interleaving (π) and convolutional encoding of the information data u by an encoder ENC2. In other words, a turbo code is obtained by combining two convolutional codes. It should be noted that an interleaved output xa' differs from the encoded data xa only in terms of its sequence and therefore is not output.

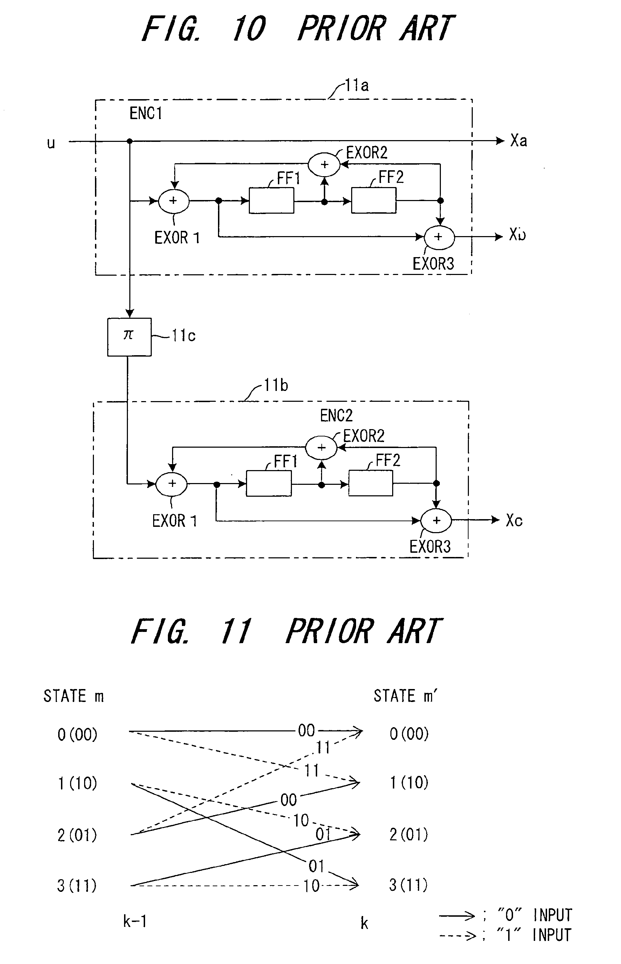

Fig. 10 is a diagram showing the details of the turbo encoder 11. Numerals 11a, 11b denote convolutional encoders (ENC1, ENC2) that are identically constructed, and numeral 11c denotes an interleaving unit (π). The convolutional encoders 11a, 11b, which are adapted to output recursive systematic convolutional codes, are each constructed by connecting two flip-flops FF1, FF2 and three exclusive-OR gates EXOR1 to EXOR3 in the manner illustrated. The flip-flops FF1, FF2 take on four states m (=0 to 3), which are (00), (01), (10), (11). If 0 or 1 is input into each of these states, the states undergo a transition as illustrated in Fig. 11 and xa, xb are output. In Fig. 11, the left side indicates the state prior to input of receive data, the right side the state after the input, the solid lines the path of the state transition when "0" is input and the dashed lines the path of the state transition when "1" is input, and 00, 11, 10, 01 on the paths indicate the values of the output signals xa, xb. For example, if "0" is input in the state 0(00), the output is 00 and the state becomes 0(00); if "1" is input, the output is 11 and the state becomes 1(10).

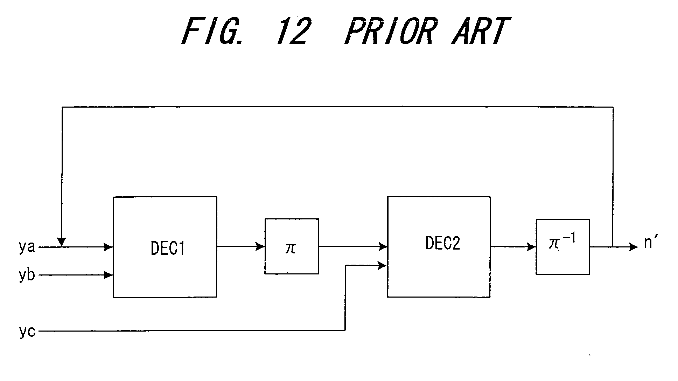

Fig. 12 shows the configuration of the turbo decoder. Turbo decoding is performed by a first element decoder DEC1 using ya and yb first among the receive signals ya, yb, yc. The element decoder DEC1 is a soft-output element decoder which outputs the likelihood of decoding results. Next, similar decoding is performed by a second element decoder DEC2 using yc and the likelihood output from the first element decoder DEC1. That is, the second element decoder DEC2 also is a soft-output element decoder which outputs the likelihood of decoding results. Here yc is a receive (received) signal corresponding to xc, which was obtained by interleaving and encoding the information data u. Accordingly, the likelihood that is output from the first element decoder DEC1 is interleaved (π) before entering the second element decoder DEC2.

The likelihood output from the second element decoder DEC2 is deinterleaved ($\pi^{-1}$) and then is fed back as the input to the first element decoder DEC1. Further, u' is decoded data (results of decoding) obtained by rendering a "0", "1" decision regarding the interleaved results from the second element decoder DEC2. The error rate is reduced by repeating the above-described decoding operation a prescribed number of times.

**EP 1 724 934 A1**

MAP element decoders can be used as the first and second element decoders DEC1, DEC2 in such a turbo element decoder.

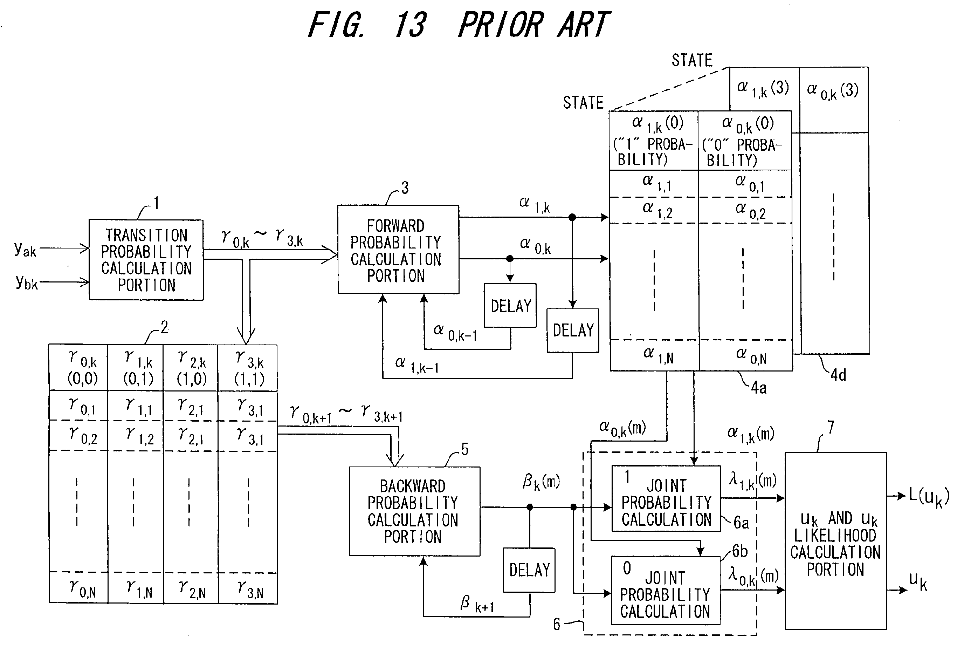

Fig. 13 shows the configuration of a MAP decoder which instantiates a first MAP decoding method of the prior art; the encoding rate R, information length N, original information u, encoded data $x_a$ and $x_b$, and receive data $y_a$ and $y_b$ are, respectively,

Encoding rate: $R = 1/2$

Information length: N

Original information: $u = \{u1, u2, u3, ..., u_N\}$

Encoded data: $x_a = \{x_{a1}, x_{a2}, x_{a3}, ..., x_{ak}, ..., x_{aN}\}$
$x_b = \{x_{b1}, x_{b2}, x_{b3}, ..., x_{bk}, ..., x_{bN}\}$

Receive data: $y_a = \{y_{a1}, y_{a2}, y_{a3}, ..., y_{ak}, .... y_{aN}\}$
$Yb = \{y_{b1}, y_{b2}, y_{b3}, ..., y_{bk}, ..., y_{bN}\}$

That is, encoded data $x_a$, $x_b$ is generated from the original information u of information length N, errors are inserted into (occur in) the encoded data at the time of reception and the data $y_a$, $y_b$ is received, and from this receive data the original information u is decoded.

If the transition probability calculation portion 1 receives $(y_{ak}, y_{bк})$ at time k, then the quantities
probability $\gamma_{0,k}$ that $(x_{ak}, x_{bx})$ is (0,0)
probability $\gamma_{1,k}$ that $(x_{ak}, x_{bk})$ is (0,1)
probability $\gamma_{2,k}$ that $(x_{ak}, x_{bk})$ is (1,0)
probability $\gamma_{3,k}$ that $(x_{ak}, x_{bk})$ is (1,1)
are each calculated and stored in memory 2.

A forward probability calculation portion 3 uses, in each state m (=0 to 1) of the previous time by one (k-1), the forward probability $\alpha_{1,k-1}(m)$ that the original data $u_{k-1}$ is "1" and the forward probability $\alpha_{0,k-1}(m)$ that the original data $u_{k-1}$ is "0" , and the transition probabilities $\gamma_{0,k}$, $\gamma_{1,k}$, $\gamma_{2,k}$, $\gamma_{3,k}$ at the calculated time k, to calculate the forward probability $\alpha_{1,k}(m)$ that the original data $u_k$ is "1" and the forward probability $\alpha_{0,k}(m)$ that the original data $u_k$ is "0", and stores the results in memory 4a to 4d. Because processing always begins from the state m=0, the forward probability initial values $\alpha_{0,0}(0) = \alpha_{1,0}(0) = 1$, $\alpha_{0,0}(m) = \alpha_{1,0}(m) = 0$ (where $m \neq 0$).

The transition probability calculation portion 1 and forward probability calculation portion 3 repeat the above calculations with k = k+1, perform calculations from k=1 to k=N, calculate the transition probabilities $\gamma_{0,k}$, $\gamma_{1,k}$, $\gamma_{2,k}$, $\gamma_{3,k}$ and forward probabilities $\alpha_{1,k}$, $\alpha_{0,k}$ at each of the times k = 1 to N, and store the results in memory 2 and 4a to 4d, respectively.

Following this, the backward probability calculation portion 5 uses the backward probability $\beta_{k+1}$ and transition probabilities $\gamma_{s,k+1}$ (s=0, 1, 2, 3) at time (k+1) to calculate the backward probabilities $\beta_k(m)$ (m=0 to 3) for each of the states m (=0 to 3) at time k. Here the initial value of k is N-1, and as trellis terminal state m=0 , $\beta_N(0)=1$, $\beta_N(1) = \beta_N(2) = \beta_N(3) = 0$ is used.

A first calculation portion 6a of the joint probability calculation portion 6 multiplies the forward probability $\alpha_{1,k}(m)$ and backward probability $\beta_k(m)$ in each state m (=0 to 3) at time k to calculate the probability $\lambda_{1,k}(m)$ that the kth item of original data $u_k$ is "1", and a second calculation portion 6b similarly uses the forward probability $\alpha_{0,k}(m)$ and backward probability $\beta_k(m)$ in each state m (0 to 3) at time k to calculate the probability $\lambda_{0,k}(m)$ that the original data $u_k$ is "0".

The $u_k$ and $u_k$ likelihood calculation portion 7 adds the "1" probabilities $\lambda_{1,k}(m)$ (m = 0 to 3) of each of the states m (=0 to 3) at time k, adds the "0" probabilities $\lambda_{0,k}(m)$ (m = 0 to 3) of each of the states m (=0 to 3) at time k, decides between "1" and "0" for the kth item of data $u_k$ based upon the results of addition, namely the magnitudes of $\Sigma_m\lambda_{1,k}(m)$ and $\Sigma_m\lambda_{0,k}(m)$, calculates the confidence (likelihood) $L(u_k)$ thereof and outputs the same.

The backward probability calculation portion 5, joint probability calculation portion 6 and $u_k$ and $u_k$ likelihood calculation portion 7 subsequently repeat the foregoing calculations with k = k-1, perform the calculations from k=1 to k=N to decide between "1" and "0" for $u_k$ at each of the times k = 1 to N, calculate the confidence (likelihood) $L(u_k)$ thereof, and output the results.

When using the first MAP decoding method of Fig. 13, there is the problem that an extremely large quantity of memory is used. That is, in the first MAP decoding method a 4xN memory area for transition probability storage and a m (number of states) x2xN memory area for forward probability storage are required, so that in all a (4+mx2)xN memory area is necessary. Further, actual calculations entail soft-decision signals, so that the required memory area is increased by a factor of approximately eight.

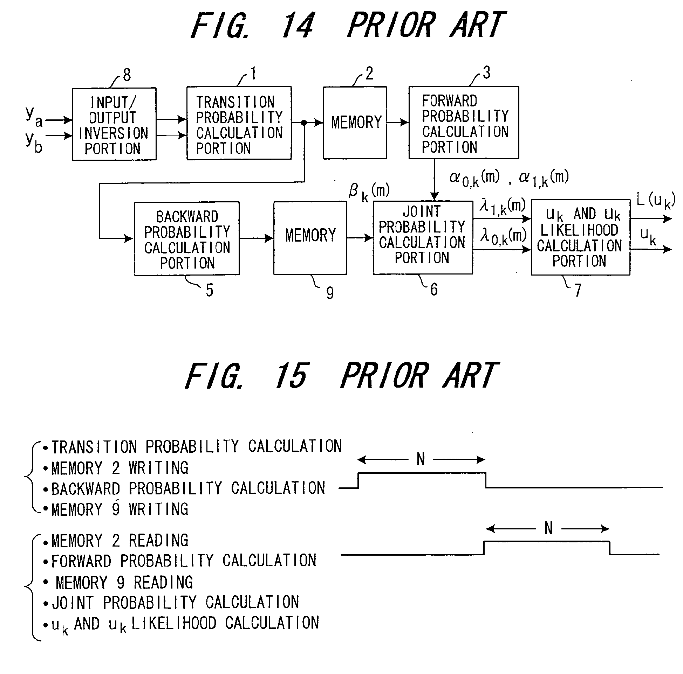

Hence in order to reduce memory requirements, a method is conceivable in which the order of forward probability calculations and backward probability calculations is inverted. Fig. 14 shows the structure of a MAP decoder which realizes such a second MAP decoding method; portions which are the same as in Fig. 13 are assigned the same symbols. The input-output inversion portion 8 inverts the output order of receive data as appropriate, and comprises memory which stores all receive data and a data output portion which outputs the receive data, either in the same order or in the opposite order of the input order. In a turbo decoder which adopts a MAP decoding method, receive data must be interleaved, and so there exists memory which stores all receive data; hence the memory for interleaving can also be used as the memory of the input-output inversion portion 8, so that there is no increased burden in terms of memory.

The transition probability calculation portion 1 uses the receive data ($y_{ak}$, $y_{bk}$) taking k (=N) as the time, and calculates the probabilities $\gamma_{0,k}$, $\gamma_{1,k}$, $\gamma_{2,k}$ and $\gamma_{3,k}$, storing the results in memory 2. The backward probability calculation portion 5 uses the backward probabilities $\beta_k(m)$ and transition probabilities $\gamma_{a,k}$ (s=0,1,2,3) at time k (=N) to calculate the backward probabilities $\beta_{k-1}(m)$ (m=0 to 3) at time k-1 for each state m (=0 to 3), and stores the results in memory 9. Subsequently, the transition probability calculation portion 1 and backward probability calculation portion 5 repeat the above calculations with k=k-1, and perform the calculations from k=N to k=1, storing the transition probabilities $\gamma_{0,k}$, $\gamma_{1,k}$, $\gamma_{2,k}$, $\gamma_{3,k}$ and the backward probabilities $\beta_k(m)$ at each of the times k=1 to N in memory 2, 9.

Thereafter, the backward probability calculation portion 3 uses the forward probabilities $\alpha_{1,k-1}(m)$ that the original data $u_{k-1}$ at time (k-1) is "1" and the forward probabilities $\alpha_{0,k-1}(m)$ that the original data $u_{k-1}$ is "0", as well as the transition probabilities $\gamma_{0,k}$, $\gamma_{1,k}$, $\gamma_{2,k}$, $\gamma_{3,k}$ at time k determined above, to calculate the forward probabilities $\alpha_{1,k}(m)$ that $u_k$ is "1" and the forward probabilities $\alpha_{0,k}(m)$ that $u_k$ is "0" at time t in each of the states m (=0 to 3). Here the initial value of k is 1.

The joint probability calculation portion 6 multiplies the forward probabilities $\alpha_{1,k}(m)$ and backward probabilities $\beta_k(m)$ in each of the states 0 to 3 at time k to calculate the probabilities $\lambda_{1,k}(m)$ that the kth original data $u_k$ is "1", and similarly uses the forward probabilities $\alpha_{0,k}(m)$ and backward probabilities $\beta_k(m)$ in each of the states 0 to 3 at time k to calculate the probabilities $\lambda_{0,k}(m)$ that the original data $u_k$ is "0". The $u_k$ and $u_k$ likelihood calculation portion 7 adds the probabilities $\lambda_{1,k}(m)$ (m=0 to 3) in each of the states 0 to 3 at time k, and adds the probabilities $\lambda_{0,k}(m)$ (m=0 to 3) in each of the states 0 to 3 at time k, and based on the magnitudes of the addition results $\Sigma_m\lambda_{1,k}(m)$ and $\Sigma_m\lambda_{0,k}(m)$, determines whether the kth data item $u_k$ is "1" or "0", and also calculates the confidence (likelihood) $L(u_k)$ thereof and outputs the same.

Thereafter, the forward probability calculation portion 3 and joint probability calculation portion 6, and the $u_k$ and $u_k$ likelihood calculation portion 7 repeat the above calculations with k=k+1, performing calculations from k=1 to k=N, and deciding between "1" and "0" for $u_k$ at each time from k=1 to N, as well as calculating the confidence (likelihood) $L(u_k)$.

In the second MAP decoding method, transition probability calculations and backward probability calculations are performed and the calculation results stored in memory in the first half, and forward probability calculations, joint probability calculations, and processing to calculate original data and likelihoods are performed in the second half, as shown in the timing chart of Fig. 15. That is, in the second MAP decoding method the forward probabilities $\alpha_{1,k}(m)$, $\alpha_{0,k}(m)$ are not stored, but the backward probabilities $\beta_k(m)$ are stored. As a result, the memory required is only the 4xN area used to store transition probabilities and the m (number of states) xN area used to store backward probabilities, so that the required memory area is (4+m)xN total, and the amount of memory required can be reduced compared with the first MAP decoding method of Fig. 13. However, the amount of memory used can be further reduced.

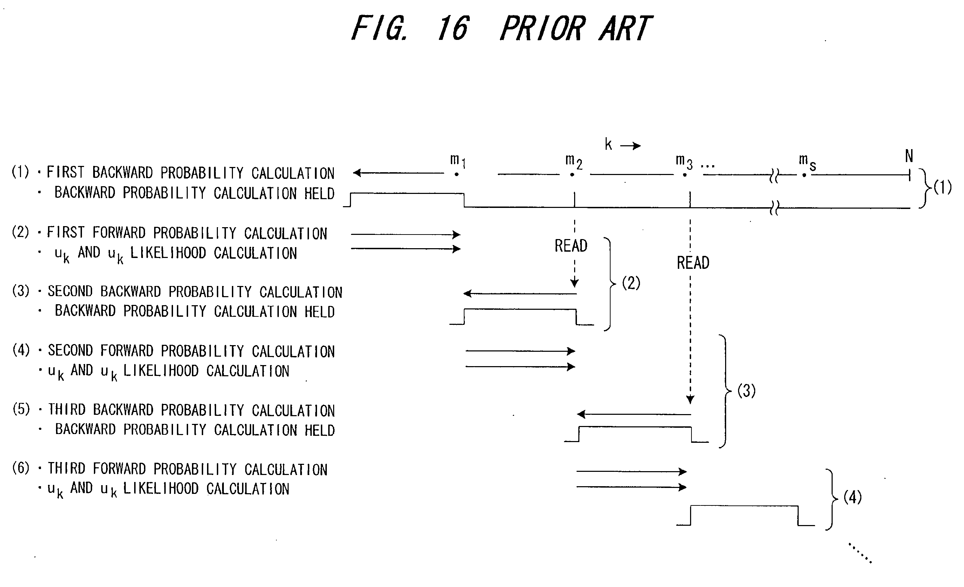

Fig. 16 is a diagram explaining the calculation sequence of a third MAP decoding method (see International Publication WO00/52833). The information length N is divided at every L places (where L=$N^{1/2}$), to obtain division points $m_s$, $m_{(s-1)}$, ..., $m_3$, $m_2$, $m_1$. Here division intervals are rounded upward to the decimal point, and there are cases in which there is an interval of the length of the remainder M smaller than the value of L.

(1) First, backward probabilities $\beta_k(m)$ (k=N to 1) are calculated in the reverse direction, starting from the Nth backward probability for k=N to the first backward probability for k=1, and discrete values for the $m_s$th backward probability $\beta m_S(m)$, the $m_{(S-1)}$th backward probability $\beta m_{(S-1)}(m)$, ..., $m_3$th backward probability $\beta m_3(m)$, and $m_2$th backward probability $\beta m_2(m)$ are stored, and the $m_1$th backward probability $\beta m_1(m)$ to first backward probability $\beta_1(m)$ are continuously stored.

(2) Next, the first forward probabilities $\alpha_{1,1}(m)$, $\alpha_{0,1}(m)$ are calculated, and using these first forward probabilities and the first backward probabilities $\beta_1(m)$ previously stored, the first decoded data $u_1$ and likelihood $L(u_1)$ are determined, and similarly, the second through $m_1$th decoded data $u_2$ to $u_{m1}$ and likelihoods $L(u_2)$ to $L(u_{m1})$ are determined. In parallel with the above, starting from the $m_2$th backward probability $\beta m_2(m)$ stored in the processing of (1), up to the $(m_1+1)$th posterior probability $\beta_{m1+1}(m)$ are calculated and stored.

(3) Next, the $(m_1+1)$th forward probabilities $\alpha_{1,m1+1}(m)$ and $\alpha_{0,m1+1}(m)$ are calculated, and using the $(m_1+1)$th forward probabilities and the above stored $(m_1+1)$th backward probabilities $\beta_{m1+1}(m)$, the $(m_1+1)$th decoded data item $u_{m1+1}$

and likelihood $L(u_{m1+1})$ are determined; and similarly, the $(m_1+2)$th to $m_2$th decoded data items $u_{m1+2}$ to $u_{m2}$ and the likelihoods $L(u_{m1+2})$ to $L(u_{m2})$ are calculated.

In parallel with this, starting from the $m_3$th backward probability $\beta_{m3+1}(m)$ stored in the processing of (1), up to the $(m_2+1)$th backward probability $\beta_{m2+1}(m)$ are calculated and stored.

(4) Then, the $(m_2+1)$th forward probabilities $\alpha_{1,m2+1}(m)$ and $\alpha_{0,m2+1}(m)$ are calculated, and using the $(m_2+1)$th forward probabilities and the above stored $(m_2+1)$th backward probability $\beta_{m2+1}(m)$, the $(m_2+1)$th decoded data item $u_{m2+1}$ and likelihood $L(u_{m2+1})$ are calculated; similarly, the $(m_2+2)$th to $m_3$th decoded data items $u_{m2+2}$ to $u_{m3}$ and likelihoods $L(u_{m2+2})$ to $L(u_{m3})$ are calculated.

In parallel with this, starting from the $m_4$th backward probability $\beta_{m4}(m)$ stored in the processing of (1), up to the $(m_3+1)$th backward probability $\beta_{m3+1}(m)$ are calculated and stored.

Similarly in (5) to (8), the $(m_3+1)$th to the Nth decoded data items $u_{m3+1}$ to $u_N$, and the likelihoods thereof $L(u_{m3+1})$ to $L(u_N)$, are calculated.

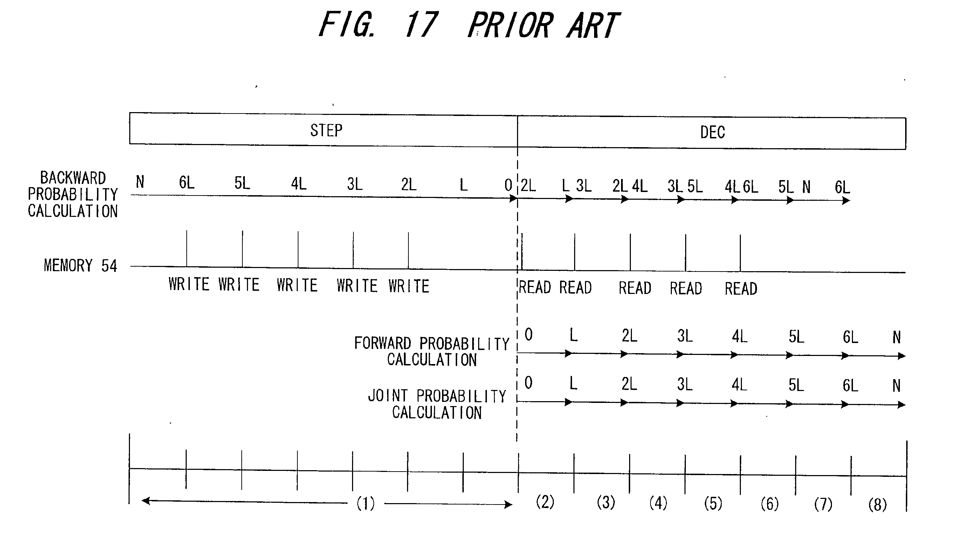

The state (1) of calculating backward probabilities is defined as the STEP state, and the states of performing backward probability calculations, forward probability calculations, and joint probability calculations in (2) to through (8) are defined as the DEC state. In the STEP state, backward probability calculations are performed for the information length N, so that N cycles of processing time are required; in the DEC state also, forward probability calculations and joint probability calculations are performed for the information length N, so that N cycles of processing time are similarly required. Fig. 17 is a timing chart for the third decoding method, to clarify the STEP state and DEC state; as is clear from the figure, in the case of the third decoding method, in the STEP state backward probability calculations are performed for information length N so that N cycles of processing time are required, and in the DEC state also forward probability calculations and joint probability calculations are performed for the information length N, so that similarly, N cycles of processing time are required.

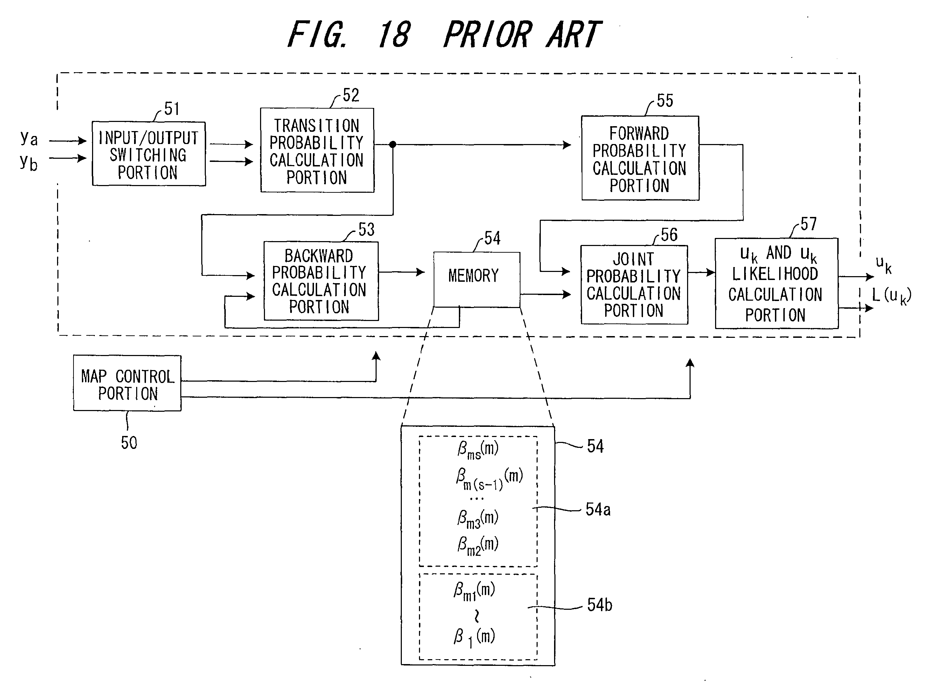

Fig. 18 shows the structure of a MAP decoder which realizes the third MAP decoding method. The MAP control portion 50 controls the entire MAP decoder, and controls the calculation timing of each portion according to the calculation sequence of Fig. 17, reading and writing of data to and from different memory portions, and similar. The input/output switching portion 51 switches as appropriate the receive data output order and performs output, and comprises memory which stores all receive data and a data output portion which outputs the receive data, either in the same order or in the opposite order of the input order.

The transition probability calculation portion 52 uses the receive data $(y_{ak}, y_{bk})$ at time k $(=N)$ to calculate $\gamma_{0,k}$, $\gamma_{1,k}$, $\gamma_{2,k}$ and $\gamma_{3,k}$. The backward probability calculation portion 53 uses the backward probabilities $\beta_k(m)$ and transition probabilities $\gamma_{s,k}$ (s=0,1,2,3) at time k $(=N)$ to calculate the backward probabilities $\beta_{k-1}(m)$ (m=0 to 3) in each state m $(=0$ to 3) at time k-1. Subsequently, the transition probability calculation portion 52 and backward probability calculation portion 53 repeat the above calculations for k=k-1, performing calculations from k=N to k=1. The backward probability calculation portion 53, in parallel with calculations of backward probabilities from k=N to k=1, stores, as discrete values, the $m_s$th backward probability $\beta m_s(m)$, the $m_{(s-1)}$th backward probability $\beta m_{(s-1)}(m)$,..., the $m_3$th backward probability $\beta m_3(m)$ and $m_2$th backward probability $\beta m_2(m)$ in the discrete backward probability storage portion 54a of memory 54, and stores the $m_1$th backward probability $\beta m_1(m)$ to the first backward probability $\beta_1(m)$ in the continuous backward probability storage portion 54b.

After this, the transition probability calculation portion 52 uses the receive data $(y_{ak}, y_{bk})$ at time k $(=1)$ to calculate the probabilities $\gamma_{0,k}$, $\gamma_{1,k}$, $\gamma_{2,k}$, $\gamma_{3,k}$. The forward probability calculation portion 55 takes k=1 and uses the forward probabilities $\alpha_{1,k-1}(m)$, $\alpha_{0,k-1}(m)$ at time (k-1), as well as the transition probabilities $\gamma_{0,k}$, $\gamma_{1,k}$, $\gamma_{2,k}$, $\gamma_{3,k}$ at time k calculated above, to calculate the forward probabilities $\alpha_{1,k}(m)$, $\alpha_{0,k}(m)$ at time k. The joint probability calculation portion 56 multiplies the forward probabilities $\alpha_{1,k}(m)$ and the backward probabilities $\beta_k(m)$ for each of the states m $(=0$ to 3) at time k, to calculate the probability $\lambda_{1,k}(m)$ that the kth original data item $u_k$ is "1", and similarly, uses the forward probabilities $\alpha_{0,k}(m)$ and backward probabilities $\beta_k(m)$ for each of the states m $(=0$ to 3) at time k to calculate the probability $\lambda_{0,k}(m)$ that the original data $u_k$ is "0".

The $u_k$ and $u_k$ likelihood calculation portion 57 calculates the sum total $\Sigma_m\lambda_{0,k}(m)$ of probabilities of "0" and the sum total $\Sigma_m\lambda_{1,k}(m)$ of probabilities of "1" for each of the states m $(=0$ to 3) at time k, and uses the following equation to output the likelihood:

$$L(u) = \log[\Sigma_m\lambda_{1,k}(m)/\Sigma_m\lambda_{0,k}(m)]$$

If L(u) > 0, $u_k$=1 is output as the decoding result; if L(u) < 0, $u_k$=0 is output as the decoding result.

Subsequently, the transition probability calculation portion 52, forward probability calculation portion 55, joint probability calculation portion 56, and $u_k$ and $u_k$ likelihood calculation portion 57 repeat the above calculations for k=k+1, perform calculations from k=1 to k=$m_1$, and calculate and output $u_k$ and the confidence (likelihood) thereof L($u_k$) at each time from k=1 to k=$m_1$.

In parallel with calculations of $u_k$ and L($u_k$) from k=1 to k=$m_1$, through control by the MAP control portion 50, the transition probability calculation portion 52 uses the receive data ($y_{ak}$, $y_{bk}$) at time k (=$m_2$) to calculate the transition probabilities $\gamma_{0,k}$, $\gamma_{1,k}$, $\gamma_{2,k}$, $\gamma_{3,k}$. The backward probability calculation portion 53 reads the backward probabilities $\beta_k(m)$ (=$\beta_{m2}(m)$) at time k (=$m_2$) from the storage portion 54a, and uses the backward probabilities $\beta_k(m)$ and transition probabilities $\gamma_{s,k}$ (s=0,1,2,3) to calculate, and store in the storage portion 54b, the backward probabilities $\beta_{k-1}(m)$ (m=0 to 3) in each of the states m (=0 to 3) at time k-1. Subsequently, the transition probability calculation portion 52 and backward probability calculation portion 53 repeat the above calculations with k=k-1, performing calculations from k=$m_2$ to k=$m_1$+1, and store the $m_2$th backward probability $\beta_{m2}(m)$ to the $m_1$+1th backward probability $\beta_{m1+1}(m)$ in the storage portion 54b.

Thereafter, the transition probability calculation portion 52 uses the receive data ($y_{ak}$, $y_{bk}$) at time k (=$m_{1+1}$) to calculate the probabilities $\gamma_{0,k}$, $\gamma_{1,k}$, $\gamma_{2,k}$, $\gamma_{3,k}$. The forward probability calculation portion 55 uses the forward probabilities $\alpha_{1,k-1}(m)$, $\alpha_{0,k-1}(m)$ at time (k-1), taking k=$m_1$+1, and the above-calculated transition probabilities $\gamma_{0,k}$, $\gamma_{1,k}$, $\gamma_{2,k}$, $\gamma_{3,k}$ at time k, to calculate the forward probabilities $\alpha_{1,k}(m)$ and $\alpha_{0,k}(m)$ in each of the states m (=0 to 3) at time k. The joint probability calculation portion 56 and the $u_k$ and $u_k$ likelihood calculation portion 57 perform calculations similar to those described above, and output the likelihood L($u_k$) and $u_k$.

Subsequently, the transition probability calculation portion 52, forward probability calculation portion 55, joint probability calculation portion 56, and $u_k$ and $u_k$ likelihood calculation portion 57 repeat the above calculations with k=k+1, performing calculations from k=$m_1$+1 to k=$m_2$, to calculate and output $u_k$ and the confidence (likelihood) thereof L($u_k$) at each time from k=$m_1$+1 to $m_2$. Further, the backward probability calculation portion 53, in parallel with the above calculations from k=$m_1$+1 to k=$m_2$, calculates backward probabilities $\beta_{m3}(m)$ to $\beta_{m2+1}(m)$, and stores the results in the storage portion 54b.

Subsequently, the ($m_2$+1)th to Nth decoded data $u_{m2+1}$ to $u_N$ and likelihoods L($u_{m2+1}$) to L($u_N$) are calculated.

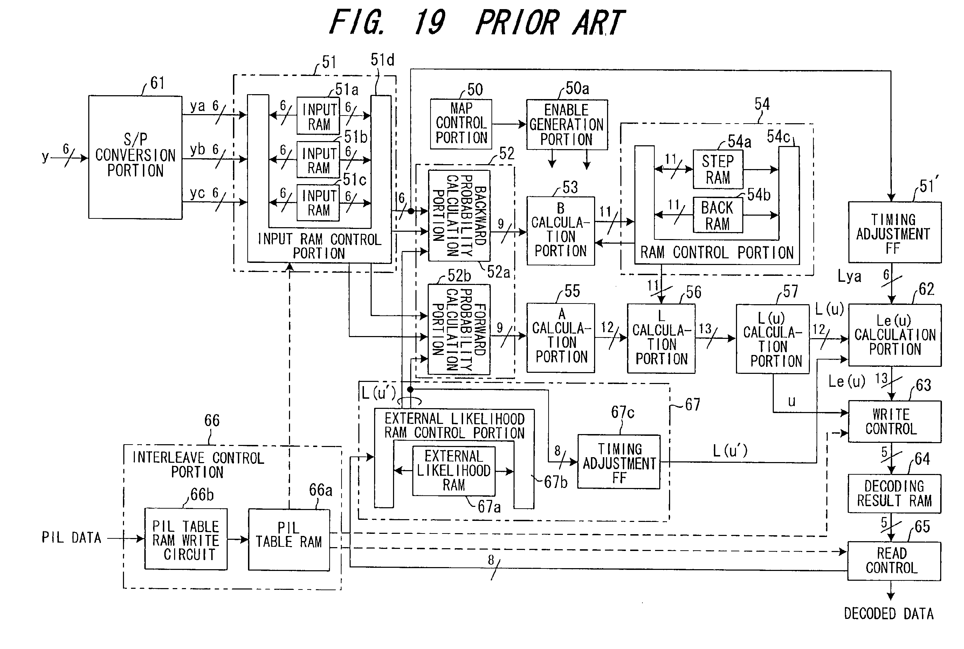

Fig. 19 shows the configuration when using a MAP decoder as the element decoders DEC1, DEC2 in a turbo decoder (see Fig. 12); a single MAP decoder performs the decoding operations in the element decoders DEC1 and DEC2. Portions which are the same in the MAP decoder of Fig. 18 are assigned the same symbols.

The MAP control portion 50 controls various timings in the MAP decoder according to the calculation sequence of Fig. 17, and controls the calculation, repeated a prescribed number of times, of decoded data and confidence information; the enable generation portion 50a provides enable signals to various portions corresponding to repetition of the decoding processing.

The input/output switching portion 51 has input RAM 51a to 51c for storage of receive data ya, yb, yc, as well as an input RAM control portion 51d which performs receive data read/write control; the receive data is output in the order of input, and the output order is switched as appropriate and output (interleaving). The transition probability calculation portion 52 calculates transition probabilities, and has a first and a second transition probability calculation portion 52a, 52b. The backward probability calculation portion (B calculation portion) 53 calculates backward probabilities as explained in Fig. 18. The memory 54 stores backward probabilities, and comprises RAM (STEP RAM) 54a which stores discrete backward probabilities, RAM (BAC RAM) 54b which stores continuous backward probabilities, and a RAM control portion 54c which controls reading/writing of backward probabilities. The forward probability calculation portion (A calculation portion) 55 calculates forward probabilities; the joint probability calculation portion (L calculation portion) 56 multiples forward probabilities and backward probabilities to calculate the probabilities that the kth data item $u_k$ is "1" and is "0"; and the likelihood calculation portion (L(u) calculation portion) 57 outputs the decoding results u as well as the posterior (backward) probabilities L (u).

The S/P conversion portion 61 performs serial/parallel conversion of receive data and inputs the data to the input/output switching portion 51. The receive data ya, yb, yc obtained through conversion is soft-decision data quantified to n bits. The external-information likelihood computation portion (Le(u) computation portion) 62 uses the posterior probabilities L(u) output from the L(u) computation portion 57 in the first MAP decoding cycle and the MAP decoder input signal Lya input from the timing adjustment portion 51' to output the external information likelihood (confidence information for this calculation) Le(u). The write control portion 63 writes the external likelihood information Le(u) to the decoding result RAM 64, and the read control portion 65 reads from the decoding result RAM 64 to perform appropriate interleaving and deinterleaving of the external likelihood information Le(u), which is output as the prior likelihood L(u') for use in the next MAP decoding cycle.

The interleave control portion 66 comprises PIL table RAM 66a which stores a Prime Interleave (PIL) pattern, and a write circuit 66b which writes the PIL pattern to RAM; the PIL pattern is read from the PIL table RAM in a prescribed order, and the input RAM control portion 51, write control portion 63, and read control portion 65 are controlled according to the PIL pattern. The external likelihood memory 67 comprises external likelihood RAM 67a and a RAM control portion 67b, and stores interleaved confidence information likelihoods Le(u) as L(u'), and the timing adjustment portion 67c takes into consideration the processing time required in performing time-adjustment of computation data to output L(u').

In turbo decoding, during the second and subsequent MAP decoding cycles, (signal Lya + prior likelihood L(u')) is used as the input signal Lya. Hence in the second MAP decoding cycle, the external-information likelihood computation portion 62 uses the posterior probability L(u) output from the L(u) computation portion 57 and the decoder input signal (= signal Lya + prior likelihood L(u')) to output the external information likelihood Le(u) to be used in the next MAP decoding cycle.

The write control portion 63 writes the external information likelihood Le(u) in memory 64 and the read control portion 65 reads the likelihood from memory 64 to perform appropriate interleaving of the external information likelihood Le(u), which is output as the prior likelihood L(u') for use in the next MAP decoding cycle. Subsequently, the external information likelihood Le(u) is similarly output.

Using the logarithms of values (and with "L" denoting the logarithm), because the equation

$$L(u) = Lya + L(u') + Le(u) \qquad\qquad (1)$$

obtains, the external-information likelihood computation portion 62 can use the equation

$$Le(u) = L(u) - Lya - L(u') \qquad\qquad (2)$$

to determine the external information likelihood Le(u). In the first cycle, L(u') = 0.

When the write control portion 63 finally outputs the decoded data u, the decoded data is written to memory 64, and in addition the external information likelihood Le(u) is written to memory 64. When the read control portion 65 outputs the decoded data u, the decoded data u is read from memory 64 and output in the writing order, and when the external information likelihood Le(u) is read, reading and output are performed according to a reading order specified by the interleave control portion 66. The external likelihood memory 67 comprises RAM 67a and a RAM control portion 67b, and stores the external information likelihood Le(u) as the prior likelihood L(u').

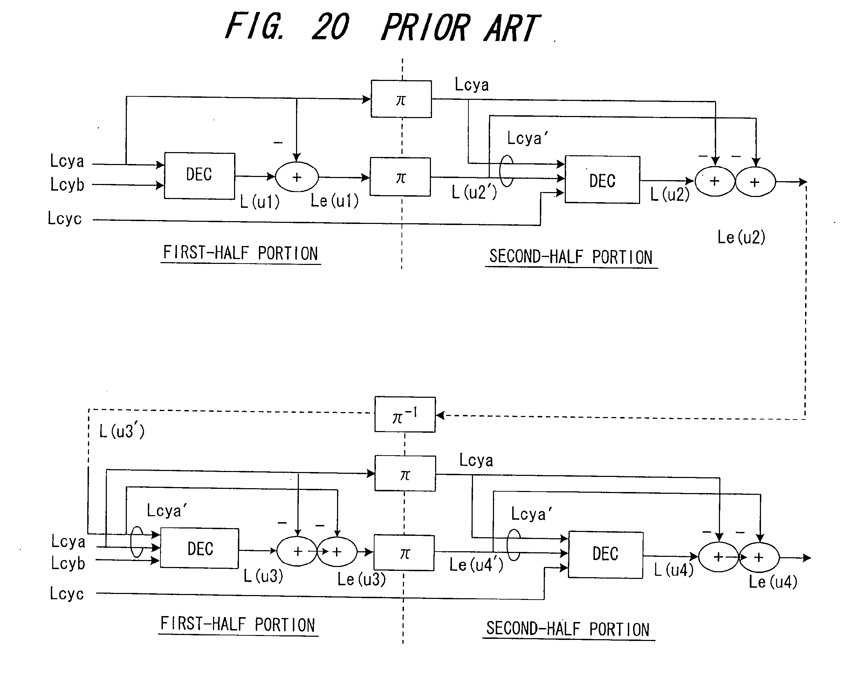

Fig. 20 explains the turbo decoding sequence. As is clear from Fig. 12, turbo decoding is repeated a plurality of times, treating a first half of decoding which uses ya, yb and a second half of decoding which uses ya, yc as one set.

In the first cycle of the first half of decoding processing, decoding is performed using receive signals Lcya, Lcyb and the likelihood $L(u_1)$ obtained is output. Next, the posterior probability $Le(u_1)$ is obtained in accordance with equation (2) (where $L(u_1') = 0$ holds), and this is interleaved to obtain $L(u_2')$.

In the first cycle of the second half of decoding processing, a signal obtained by interleaving the receive signal Lcya and the a prior likelihood $L(u_2')$ obtained in the first half of decoding processing are regarded as a new receive signal Lcya', decoding is performed using Lcya' and Lcyc, and the likelihood $L(u_2)$ obtained is output. Next, the prior likelihood $Le(u_2)$ is found in accordance with equation (2) and this is interleaved to obtain $L(u_3')$.

In the second cycle of the first half of decoding processing, the receive signal Lcya and the prior likelihood $L(u_3')$ obtained in the second half of decoding processing are regarded as a new receive signal Lcya', decoding is performed using Lcya' and Lcyb, and the likelihood $L(u_3)$ obtained is output. Next, the prior likelihood $Le(u_3)$ is found in accordance with the above equation, and is interleaved to obtain $L(u_4')$.

In the second cycle of the second half of decoding processing, a signal obtained by interleaving the receive signal Lcya and the prior likelihood $L(u_4')$ obtained in the first half of decoding processing are regarded as a new receive signal Lcya', decoding is performed using Lcya' and Lcyc, and the likelihood $L(u_4)$ obtained is output. Next, the prior likelihood $Le(u_4)$ is found using equation (2) and is interleaved to obtain $L(u_5')$. The above-described decoding processing is subsequently repeated.

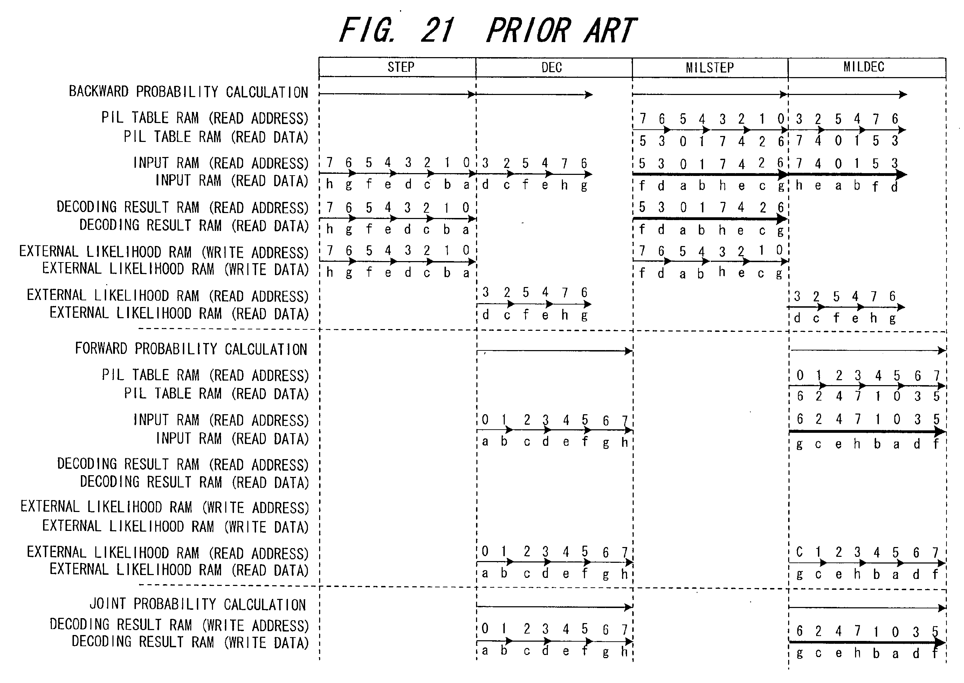

Fig. 21 is a timing diagram for the turbo decoder of Fig. 19, divided into a first-half portion in which interleaving is not performed and a second-half portion in which interleaving is performed; in the second-half corresponding to interleaving, the STEP state is called the MILSTEP state, and the DEC state is called the MILDEC state. In order to facilitate explanation, in Fig. 21 parameters which are not actually possible are assumed, with N=8 bits and the division length L=2 bits.

In the STEP state of the first half, the turbo decoder reads input data from the input RAM units 51a to 51c in the order of addresses (7, 6, ..., 1, 0) and calculates transition probabilities, as well as calculating backward probabilities, and stores as discrete values the backward probabilities $\beta_6(m)$, $\beta_4(m)$, $\beta_2(m)$ at L (=2) intervals, and also continuously stores the backward probabilities $\beta_1(m)$ to $\beta_0(m)$. In parallel with this, the external information likelihoods Le(u) stored in the previous calculation cycle are read from the decoding result RAM 64 in the order of addresses beginning from the end (7, 6, ..., 1, 0), and these are written to the external likelihood RAM 67a in the order of addresses (7, 6, ..., 1, 0).

In the DEC state of the first half, the turbo decoder reads input data from the input RAM units 51a to 51c in the order of addresses (0, 1, 2, ..., 6, 7), calculates transition probabilities, also reads prior likelihoods L(u') from the external likelihood RAM 67a in the order of addresses (0, 1, 2, ..., 6, 7), and uses these transition probabilities and prior likelihoods L(u') to calculate forward probabilities. Further, the turbo decoder uses the forward probabilities thus obtained and the calculated backward probabilities to calculate joint probabilities, and also calculates external information likelihoods Le(u) and writes these to decoding result RAM 64 in the order of addresses (0, 1, 2, ..., 6, 7). In parallel with the above, the turbo decoder uses the backward probabilities stored as discrete values, the input data, and the prior likelihoods L(u') to calculate continuous backward probabilities.

In the MIL STEP state of the second half, the turbo decoder reads input data from input RAM 51a to 51c in the order of addresses (5, 3, 0, 1, 7, 4, 2, 6) indicated by the PIL pattern, and calculates transition probabilities, and also calculates backward probabilities. In parallel with this, external information likelihoods Le(u) previously calculated and stored are read from the decoding result RAM 64 in the order of addresses (5, 3, 0, 1, 7, 4, 2, 6) indicated by the PIL pattern, and are written to the external likelihood RAM 67a in the order of addresses (7, 6, ..., 1, 0).

In the MILDEC state of the second half, the turbo decoder reads input data (gcehbadf) from the input RAM units 51a to 51c in the order of addresses (6, 2, 4, 7, 1, 0, 3, 5) indicated by the PIL pattern and calculates transition probabilities, reads prior likelihoods L(u') (=gcehbadf) from the external likelihood RAM 67a in the order of addresses (0, 1, 2, ..., 6, 7), and uses these transition probabilities and prior likelihoods L(u') to calculate forward probabilities. Further, the turbo decoder uses the forward probabilities thus obtained and the calculated backward probabilities to calculate joint probabilities, calculates external information likelihoods Le(u) (=gcehbadf), and writes the results to decoding result RAM 64 in the order of addresses (6, 2, 4, 7, 1, 0, 3) indicated by the PIL pattern (interleaving). In parallel with the above, the turbo decoder uses the backward probabilities stored as discrete values, input data, and prior likelihoods L(u') to continuously calculate backward probabilities.

In the MILDEC state, data for backward probability calculation and data for forward probability calculation are read simultaneously from the input RAM 51a; because the input RAM 51a is dual-port RAM, simultaneous reading is possible. Also, after various calculations the decoding results are written to decoding result RAM 64 in the order of addresses which is also the PIL pattern, but one data item is written in one cycle, so that RAM is not accessed simultaneously.

In the third MAP decoding method, when $m_1$=L, $m_2$=2L, $m_3$=3L, ..., the memory capacity required to store backward probabilities is only that expressed by Lxm+(s-1) (where m is the number of states). Moreover, backward probabilities are calculated in reverse direction from the Nth backward probability to the first backward probability, the backward probabilities thus obtained are stored as discrete values, and when necessary calculation of the required number of backward probabilities can begin from the discretely stored backward probabilities, so that the backward probabilities $\beta_k(m)$ can be calculated accurately, and the accuracy of MAP decoding can be improved.

However, in the case of the third MAP decoding method, in the STEP state (see Fig. 17) backward probability calculations are performed for the information length N, so that N cycles of processing time are required, and in the DEC state also, forward probability calculations and joint probability calculations are performed for the information length N, so that N cycles of processing time are similarly required, and hence there is the problem that processing time totaling 2xN cycles is necessary. Consequently when decoding data with a long information length N within a limited amount of time, a plurality of MAP decoders must be mounted, increasing the scale of the circuitry.

Moreover, in the case of the third decoding method, both backward probability calculation and forward probability calculation must be performed simultaneously, and consequently each of the RAM units must be accessed simultaneously. In this case, a problem is avoided by providing two RAM units or by using dual-port RAM, but the configuration is expensive.

Hence it is desirable to shorten the time required for MAP decoding, and reduce the circuit scale, while retaining the advantages of the above third decoding method.

It is further desirable to reduce the amount of memory required.

The present invention provides a maximum a posteriori probability (MAP) decoding method and decoding apparatus in which the first to kth encoded data items of encoded data resulting from the encoding of information of length N are used to calculate the kth forward probability, and in addition the Nth to kth encoded data items are used to calculate the kth backward probability, and these probabilities are used to output the kth decoding result.

A MAP decoding method according to a first aspect of the invention has:

(a) a first step, when dividing an information length N into a plurality of sections, of calculating the backward probabilities in the reverse direction from the Nth backward probability to the (n+1)th section and of storing the backward probabilities at each division point (between sections), and in parallel with the backward probability calculations, of calculating the forward probabilities from the first forward probability in the forward direction to the nth section and of storing the forward probabilities at each division point (between sections);

(b) a second step of calculating the backward probabilities from the (n+1)th section to the final section using the stored backward probabilities, and of calculating the forward probabilities from the (n+1)th section to the final section, and of using these backward probabilities and forward probabilities to determine decoding results from the (n+1)th section to the final section; and,

(c) a third step of using the stored forward probabilities to calculate the forward probabilities from the nth section to the first section, and of using the stored backward probability at the nth division point to calculate the backward probabilities from the nth section to the first section, and of using these forward probabilities and backward probabilities to determine the decoding results from the nth section to the first section.

The memory accessed simultaneously for forward probability calculations and backward probability calculations comprises two single-port RAM units the minimum number of addresses of which is N/2; moreover, addresses are generated such that single-port RAM is not accessed simultaneously, and in cases where it is not possible to generate addresses so as not to access the single-port RAM simultaneously, the memory is configured as dual-port RAM, or memory having two banks.

Further, the memory accessed simultaneously for forward probability calculations and backward probability calculations comprises two single-port RAM units the minimum number of addresses of which is N/2; moreover, addresses are generated such that single-port RAM is not accessed simultaneously, and in cases where the single-port RAM is accessed simultaneously due to interleave processing, an interleave-processed address is returned to the original address and data is stored in the memory, so that addresses are generated such that the single-port RAM is not accessed simultaneously.

A decoding apparatus according to a second aspect of the invention comprises a backward probability calculation portion for calculating backward probabilities, a backward probability storage portion for storing calculated backward probabilities, a forward probability calculation portion for calculating forward probabilities, a forward probability storage portion for storing calculated forward probabilities, a decoding result calculation portion for using the kth forward probability and the kth backward probability to determine the kth decoding result, and a control portion for controlling calculating timing of the backward probability calculation portion, forward probability calculation portion, and of the decoding result calculation portion, and:

(a) when dividing an information length N by division lengths L, such that the number of divisions including the remainder is 2n (where 2n is an even number) or 2n+1 (where 2n+1 is an odd number), the backward probability calculation portion calculates the backward probabilities in the reverse direction from the Nth backward probability to the (n+1)th section and stores the backward probabilities at each division point as discrete values in the backward probability storage portion, and in parallel with the backward probability calculations, the forward probability calculation portion calculates the forward probabilities from the first forward probability in the forward direction to the nth section and stores the forward probabilities at each division point as discrete values in the forward probability storage portion;

(b) the backward probability calculation portion calculates the backward probabilities from the (n+1)th section to the final section using the stored discrete values of backward probabilities, the forward probability calculation portion calculates forward probabilities from the (n+1)th section to the final section, and the decoding result calculation portion uses these backward probabilities and forward probabilities to determine decoding results from the (n+1)th section to the final section; and,

(c) the forward probability calculation portion uses the stored discrete values of forward probabilities to calculate the forward probabilities from the nth section to the first section, the backward probability calculation portion uses the stored backward probability at the nth division point to calculate the backward probabilities from the nth section to the first section, and the decoding result calculation portion uses these forward probabilities and backward probabilities to determine the decoding results from the nth section to the first section.

According to aspects of the invention, N/2 cycles are required for STEP state processing and N cycles for DEC state processing, so that in total only 3N/2 cycles are required; consequently the decoding processing time can be shortened compared with the decoding processing of the prior art, which requires 2N cycles. If it were necessary to perform turbo decoding twice within time T, and moreover the decoding time for one cycle were T/2 or greater, then it would be necessary to provide two MAP decoders. Therefore, if a single cycle of decoding processing time in turbo decoding is T/2 or less, then the circuit scale of a single MAP decoder can be decreased.

Further, when the number of divisions is an odd number by beginning backward probability calculation before forward probability calculation, and when the number of divisions is an even number, by beginning forward probability calculations before backward probability calculations, the backward probability calculation processing and the forward probability calculation processing can be ended simultaneously in the STEP state, and the decoding processing time can be shortened.

Further, memory accessed simultaneously for forward probability calculations and for backward probability calculations can be configured as two single-port RAM units the minimum number of addresses of which is N/2, and moreover if addresses are generated such that single-port RAM is not accessed simultaneously, the amount of memory used can be decreased, or the need to use dual-port RAM can be eliminated and costs can be reduced. Also, when single-port RAM is accessed simultaneously due to interleave processing, an interleave-processed address is returned to the original address and data is stored, so that the single-port RAM is not accessed simultaneously. As a result, the amount of memory used can be decreased and costs can be reduced.

Other features and advantages of the present invention will be apparent from the following description taken in conjunction with the accompanying drawings, in which:

Fig. 1 shows the configuration of a turbo decoder of an embodiment of the invention;

Fig. 2 is a diagram explaining the calculation sequence of a MAP decoding method, for a case in which when the number of information bits N is divided by a division length L the number of divisions is odd;

Fig. 3 is a diagram explaining the calculation sequence of a MAP decoding method, for a case in which when the number of information bits N is divided by a division length L the number of divisions is even;

Fig. 4 shows the flow of control processing of a MAP control portion;

Fig. 5 explains a case in which two single-port RAM units with N/2 addresses are mounted;

Fig. 6 shows the calculation sequence of the turbo decoder of Fig. 1;

Fig. 7 shows the overall calculation sequence of the turbo decoder of Embodiment 3;

Fig. 8 shows the configuration of the turbo decoder of Embodiment 3;

Fig. 9 is a summary diagram of a communication system;

Fig. 10 shows the configuration of a turbo decoder;

Fig. 11 is a diagram of state transitions in a convolutional encoder;

Fig. 12 shows the configuration of a turbo decoder;

Fig. 13 shows the configuration of a first MAP decoder of the prior art;

Fig. 14 shows the configuration of a second MAP decoder of the prior art;

Fig. 15 explains the calculation sequence of the second MAP decoding method;

Fig. 16 explains the calculation sequence of a third MAP decoding method of the prior art;

Fig. 17 explains another calculation sequence of the third MAP decoding method;

Fig. 18 shows the configuration of a third MAP decoder of the prior art;

Fig. 19 shows the configuration of a turbo decoder of the prior art;

Fig. 20 explains the operation of a turbo decoder; and,

Fig. 21 shows the timing (explains the calculation sequence) of the turbo decoder of Fig. 19.

A decoding apparatus is provided in which, using the first to kth encoded data among encoded data resulting from encoding of information of length N, the kth forward probability is calculated, using the Nth to kth encoded data the kth backward probability is calculated, and using these probabilities, the kth decoding result is output.

The decoding apparatus comprises a backward probability calculation portion which calculates backward probabilities, a backward probability storage portion which stores calculated backward probabilities, a forward probability calculation portion which calculates forward probabilities, a forward probability storage portion which stores calculated forward probabilities, a decoding result calculation portion which uses the kth forward probability and the kth backward probability to calculate the kth decoding result, and a control portion which controls the calculation timing of the backward probability calculation portion, forward probability calculation portion, and decoding result calculation portion.

The decoding method of this decoding apparatus has the following first to third steps.

The first step comprises a step of calculating backward probabilities from the Nth backward probability in reverse direction to the (n+1)th section, and storing the backward probabilities at each division point as discrete values, as well as storing the backward probability of the (n+1)th division section continuously, and a step of calculating forward probabilities from the first forward probability to the nth section in the forward direction, in parallel with the backward probability calculations, and of storing the forward probabilities at each division point as discrete values.

The second step comprises a step of calculating the forward probability of the (n+1)th division section, using the forward probabilities and the stored backward probability of the (n+1)th division section to calculate the decoding result for the (n+1)th division section, and in parallel with these calculations, of calculating and storing backward probabilities from the backward probability of the stored (n+2) division point, in the reverse direction, to the backward probability of the (n+2)th division section; a step of calculating the forward probability of the (n+2)th division section, of using the forward probability and the stored backward probability of the (n+2)th division section to calculate the decoding result for the (n+2)th division section, and in parallel with this, calculating backward probabilities from the stored backward probability of the (n+3)th division point, in reverse direction, to the (n+3)th division section; and, a step of similarly calculating decoding results up to the final division section.

The third step comprises a step of calculating and storing the backward probability from the stored backward probability of division point n, in reverse direction, for the nth division section; a step of calculating the forward probability for the nth division section using the stored forward probability for the (n-1)th division point, using the forward probability and the stored backward probability for the nth division section to calculate decoding results for the nth division section, and in parallel with these calculations, calculating and storing the backward probability for the (n-1)th division section in the reverse direction; a step of using the stored forward probability for the (n-2)th division point to calculate the forward probabilities for the (n-1)th division section, using the forward probabilities and the stored backward probabilities for the (n-1)th division section to calculate decoding results for the (n-1)th division section, and in parallel with these calculations, calculating and storing the backward probabilities for the (n-2)th division section in the reverse direction; and, similarly calculating the decoding results up to the final division section.

Embodiment 1

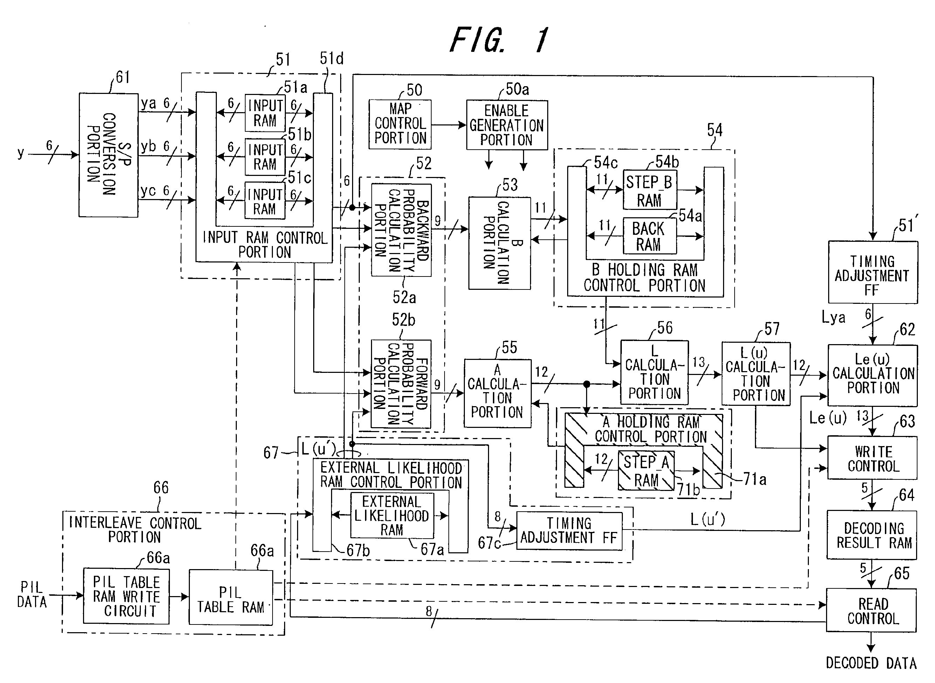

Fig. 1 shows the configuration of a turbo decoder of an embodiment; portions which are the same as in the conventional configuration of Fig. 19 are assigned the same symbols. Points of difference are: (1) in the STEP state, together with backward probability calculations, the forward probability calculation portion 55 performs forward probability calculations, and under control of the memory control portion 71a the forward probabilities are stored as discrete values for each division length L in the forward probability memory (STEP A memory) 71b; and, (2) in the DEC state, the forward probabilities for every division length L are read as appropriate and input to the forward probability calculation portion 55, and forward probabilities are calculated and output continuously for a division length L.

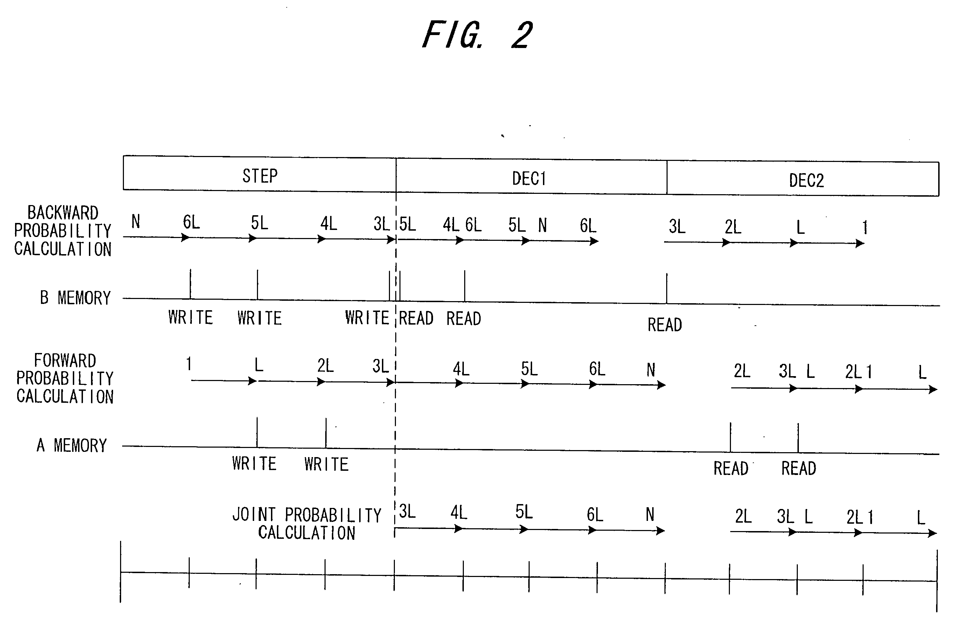

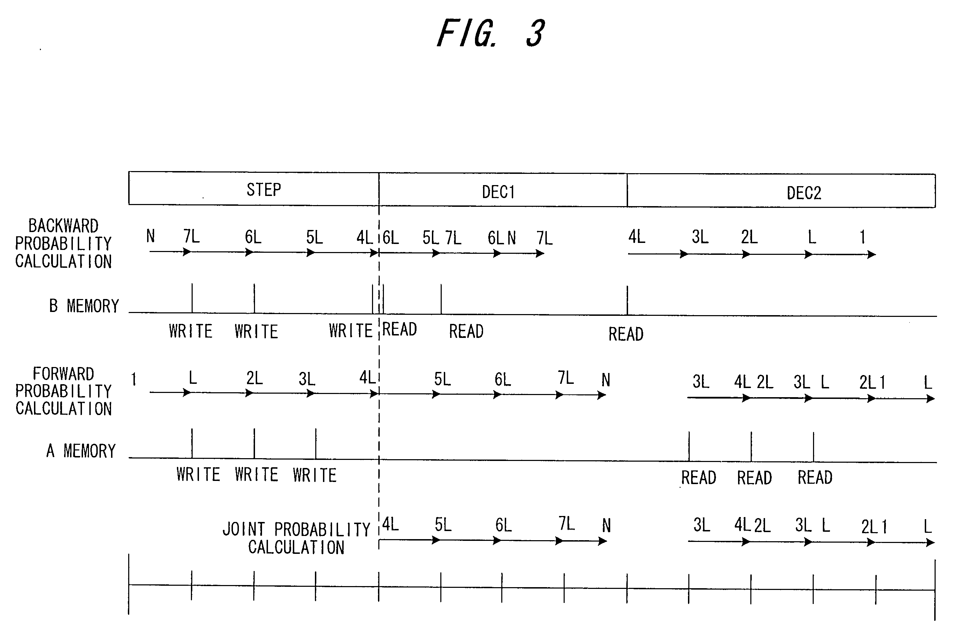

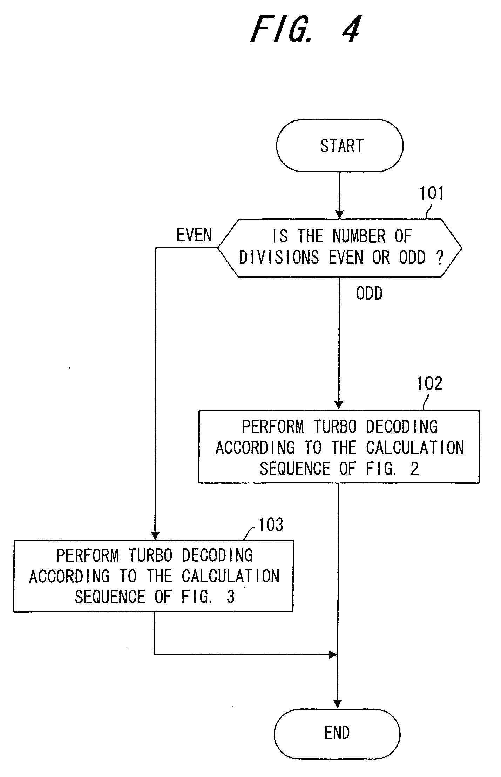

Fig. 2 explains the calculation sequence for a MAP decoding method of this embodiment, when, upon dividing the number of information bits N by the division length L, the number of divisions is odd. The information length N is divided by the division length L in advance, obtaining division points 6L, 5L, ..., 2L, L. Division sections are rounded up to the decimal point, and there may be a section in which a remainder M(=N-6L) smaller than the value of L exists.

(1) In the STEP state, the backward probability calculation portion 53 begins from the Nth backward probability with k=N and calculates backward probabilities $\beta_k(m)$ (k=N to 6L) in reverse direction, until the 6Lth backward probability with k=6L, and writes the 6Lth backward probabilities $\beta_{6L}(m)$ to B memory 54b.

(2) Then, the backward probability calculation portion 53 calculates the backward probabilities for k=6L to 5L, and the forward probability calculation portion 55 calculates forward probabilities for k=1 to L; the 5Lth backward probabilities $\beta_{5L}(m)$ are written to B memory 54b, and the Lth forward probabilities $\alpha_L(m)$ are written to A memory 71b. Subsequently, the backward probability calculation portion 53 calculates backward probabilities, storing to B memory 54b the backward probabilities $\beta_{6L}(m)$, $\beta_{5L}(m)$, $\beta_{4L}(m)$, $\beta_{3L}(m)$ as discrete values, and stores in memory 54a the continuous backward probabilities $\beta_{4L}(m)$ to $\beta_{3L+1}(m)$. The forward probability calculation portion 55 calculates forward probabilities, and stores to A memory 71b the forward probabilities $\alpha_L(m)$, $\alpha_{2L}(m)$, $\alpha_{3L}(m)$ (however, $\beta_{4L}(m)$ and $\alpha_{3L}(m)$ need not be stored).

When calculation of (number of divisions - 1)x L/2 (in Fig. 2, equal to 3L) backward probabilities and forward probabilities is completed, the STEP state processing ends, and processing for DEC1 in the first DEC state is begun.

(3) In the DEC1 state, the forward probability calculation portion 55 calculates the (3L+1)th forward probabilities $\alpha_{3L+1}(m)$, and the joint probability calculation portion 56 uses the (3L+1)th forward probabilities $\alpha_{3L+1}(m)$ and the (3L+1)th backward probabilities $\beta_{3L+1}(m)$ calculated and stored in the STEP state to calculate the joint probabilities, and the L(u) calculation portion 57 calculates and outputs the (3L+1)th decoded data $u_{3L+1}$ and the likelihood L$(u_{3L+1})$. Subsequently, the (3L+2)th to 4Lth decoded data $u_{3L+1}$ to $u_{4L}$ and likelihoods L$(u_{3L+2})$ to L$(u_{4L})$ are similarly calculated. In parallel with the above calculations, the backward probability calculation portion 53 calculates and stores in memory 54a the backward probabilities $\beta_{5L}(m)$ to $\beta_{4L+1}(m)$, starting from the 5Lth backward probabilities $\beta_{5L}(m)$ stored in the processing of (2) above.

(4) Next, the forward probability calculation portion 55 calculates the (4L+1)th forward probabilities $\alpha_{4L+1}(m)$, the joint probability calculation portion 56 uses the (4L+1)th forward probabilities $\alpha_{4L+1}(m)$ and the (4L+1)th backward probabilities $\beta_{4L+1}(m)$ calculated and stored in (3) to calculate joint probabilities, and the L(u) calculation portion 57 calculates and outputs the (4L+1)th decoded data $u_{4L+1}$ and likelihood L$(u_{4L+1})$. Subsequently, the (4L+2)th to 5Lth decoded data $u_{4L+2}$ to $u_{5L}$ and the likelihoods L$(u_{4L+2})$ to L$(u_{5L})$ are similarly calculated. In parallel with the above calculations, the backward probability calculation portion 53 calculates and stores in memory 54a the backward probabilities $\beta_{6L}(m)$ to $\beta_{5L+1}(m)$, starting from the 6Lth backward probabilities $\beta_{6L}(m)$ stored in the processing of (2). Subsequently, the 5L+1th to Nth decoded data $u_{5+1}$ to $u_N$ and likelihoods L$(u_{5+1})$ to L$(u_N)$ are similarly calculated, after which the DEC1 state processing is completed, and the DEC2 state is begun.

(5) In the DEC2 state, the backward probability calculation portion 53 calculates and stores the backward probabilities $\beta_{3L}(m)$ to $\beta_{2L+1}(m)$, starting from the 3Lth backward probabilities $\beta_{3L}(m)$ stored in the processing of (2).

Next, the forward probability calculation portion 55 uses the forward probabilities $\alpha_{2L}(m)$ stored in A memory 71b to calculate the (2L+1)th forward probabilities $\alpha_{2L+1}(m)$, the joint probability calculation portion 56 uses the (2L+1)th forward probabilities $\alpha_{2L+1}(m)$ and the (2L+1)th backward probabilities $\beta_{2L+1}(m)$ calculated and stored in the above processing to perform joint probability calculations, and the L(u) calculation portion 57 calculates and outputs the (2L+1)th decoded data $u_{2L+1}$ and the likelihood L$(u_{2L+1})$. Subsequently, the (2L+2)th to 3Lth decoded data $u_{2L+2}$ to $u_{3L}$ and likelihoods L$(u_{2L+2})$ to L$(u_{3L})$ are similarly calculated. In parallel with the above calculations, the backward probability calculation portion 53 calculates and stores in memory 54a the backward probabilities $\beta_{2L}(m)$ to $\beta_{L+1}(m)$, starting from the 2Lth backward probabilities $\beta_{2L}(m)$.

Subsequently, similar processing is used to calculate the first to 3Lth decoded data $u_1$ to $u_{3L}$ and likelihoods L$(u_1)$ to L$(u_{3L})$, after which the turbo decoding processing ends.

By means of the above turbo decoding processing, N/2 cycles are required for STEP state processing and N cycles are required for DEC state processing, so that a total of only 3N/2 cycles are required. Hence the decoding processing time can be shortened compared with the conventional decoding processing shown in Fig. 17, in which 2N cycles are required.

Fig. 3 explains the calculation sequence of a MAP decoding method of this embodiment , for a case in which when the number of information bits N is divided by the division length L, the number of divisions is even.

(1) When the number of divisions is even, calculations in the STEP state begin from forward probabilities. The forward probability calculation portion 55 calculates forward probabilities for the receive data k=1 to L, and stores the Lth forward probabilities $\alpha_L(m)$ in A memory 71a. While calculating forward probabilities for k=1 to L, the backward probability calculation portion 53 calculates backward probabilities for N to 7L, and writes the 7Lth backward probabilities $\beta_{7L}(m)$ to B memory 54b. The above is an example in which calculation of backward probabilities for N to 7L ends simultaneously with the time at which calculation of the forward probabilities for 0 to L ends; but the forward probability calculations and backward probability calculations may be begun simultaneously. In this case, depending on the information length N, the timing may be such that no calculations are performed between the backward probability calculations from N to 7L and the backward probability calculations from 7L to 6L.

Next, the forward probability calculation portion 55 calculates forward probabilities for receive data from k=L to 2L, and stores the calculated forward probability $\alpha_{2L}(m)$ in A memory 71b. Simultaneously, backward probability calculations are performed for k=7L to 6L, and the calculated backward probability $\beta_{6L}(m)$ is written to B memory 54b.

Subsequently, the forward probability calculation portion 55 calculates forward probabilities, and stores the forward probabilities $\alpha_L(m)$, $\alpha_{2L}(m)$, $\alpha_{3L}(m)$, $\alpha_{4L}(m)$ in A memory 71b as discrete values. The backward probability calculation portion 53 calculates backward probabilities, and stores the backward probabilities $\beta_{7L}(m)$, $\beta_{6L}(m)$, $\beta_{5L}(m)$, $\beta_{4L}(m)$ in B memory 54b as discrete values, and also stores continuously the backward probabilities $\beta_{5L}(m)$ to $\beta_{4L+1}(m)$ in the memory 54a. It is not necessary to store $\beta_{5L}(m)$ and $\alpha_{4L}(m)$.

When calculation of the backward probabilities and forward probabilities up to (number of divisions)×L/2 (in Fig. 2, 4L) is completed, the processing of the STEP state ends, and the processing of the first DEC state DEC1 is begun.

(2) In the DEC1 state, the forward probability calculation portion 55 calculates the (4L+1)th forward probabilities $\alpha_{4L+1}(m)$, the joint probability calculation portion 56 uses the (4L+1)th forward probabilities $\alpha_{4L+1}(m)$ and the (4L+1)th backward probabilities $\beta_{4L+1}(m)$ calculated and stored in the STEP state to calculate the joint probability, and the L(u) calculation portion 57 calculates and outputs the (4L+1)th decoded data $u_{4L+1}$ and the likelihood $L(u_{4L+1})$. Subsequently, the (4L+2)th to 5Lth decoded data $u_{4L+2}$ to $u_{5L}$ and likelihoods $L(u_{4L+2})$ to $L(u_5)$ are calculated. In parallel with the above calculations, the backward probability calculation portion 53 calculates and stores in memory 54a the backward probabilities $\beta_{6L}(m)$ to $\beta_{5L+1}(m)$, starting from the 6Lth backward probabilities $\beta_{6L}(m)$ stored in the processing of (1).

(3) Next, the forward probability calculation portion 55 calculates the (5L+1)th forward probabilities $\alpha_{5L+1}(m)$, the joint probability calculation portion 56 uses the (5L+1)th forward probabilities $\alpha_{5L+1}(m)$ and the (5L+1)th backward probabilities $\beta_{5L+1}(m)$ calculated and stored in (2) to calculate joint probabilities, and the L(u) calculation portion 57 calculates and outputs the (5L+1)th decoded data $u_{5L+1}$ and likelihood $L(u_{5L+1})$. Subsequently, the (5L+2)th to 6Lth decoded data $u_{5L+2}$ to $u_{6L}$ and likelihoods $L(u_{5L+2})$ to $L(u_{6L})$ are similarly calculated. In parallel with the above calculations, the backward probability calculation portion 53 calculates and stores in memory 54a the backward probabilities $\beta_{7L}(m)$ to $\beta_{6L+1}(m)$, starting from the 7L backward probabilities $\beta_{7L}(m)$ stored in the processing of (1). Subsequently, the 6L+1th to Nth decoded data $u_{6L+1}$ to $u_N$ and likelihoods $L(u_{6L+1})$ to $L(u_N)$ are similarly calculated, upon which the DEC1 state processing ends, and the DEC2 state is begun.

(4) In the DEC2 state, the backward probability calculation portion 53 calculates and stores the backward probabilities $\beta_{4L}(m)$ to $\beta_{3L+1}(m)$, starting from the 4L backward probabilities $\beta_{4L}(m)$ stored in the processing of (1).

Next, the forward probability calculation portion 55 uses the forward probabilities $\alpha_{3L}(m)$ stored in A memory 71b to calculate the (3L+1)th forward probabilities $\alpha_{3L+1}(m)$, the joint probability calculation portion 56 uses the (3L+1)th forward probabilities $\alpha_{3L+1}(m)$ and the (3L+1)th backward probabilities $\beta_{3L+1}(m)$ calculated and stored in the above processing to calculate joint probabilities, and the L(u) calculation portion 57 calculates and outputs the (3L+1)th decoded data $u_{3L+1}$ and likelihood $L(u_{3L+1})$. Subsequently, the (3L+2)th to 4Lth decoded data $u_{3L+2}$ to $u_{4L}$ and likelihoods $L(u_{3L+2})$ to $L(u_{4L})$ are similarly calculated. In parallel with the above, the backward probability calculation portion 53 calculates and stores in memory 54a the 3Lth backward probabilities $\beta_{3L}(m)$ to $\beta_{2L+1}(m)$, starting from the backward probabilities $\beta_{3L}(m)$.

subsequently, similar processing is performed to calculate the first to 4Lth decoded data $u_1$ to $u_{4L}$ and likelihoods $L(u_1)$ to $L(u_{4L})$, after which the turbo decoding processing ends.

By means of the above turbo decoding processing, N/2 cycles are required for STEP state processing and N cycles are required for DEC state processing, so that a total of only 3N/2 cycles are required. Hence the decoding processing time is shortened compared with the conventional decoding processing of Fig. 17, which requires 2N cycles.

Fig. 4 shows the flow of control processing of the MAP control portion 50 of this embodiment. A judgment is made as to whether the number of divisions is an even number or an odd number (step 101); if odd, turbo decoding processing is performed according to the calculation sequence of Fig. 2 (step 102), and if even, turbo decoding processing is performed according to the calculation sequence of Fig. 3 (step 103).

Embodiment 2

As is clear from the calculation sequence of Fig. 21, in the example of the prior art it is necessary to simultaneously access the input RAM 51a to 51c, external likelihood RAM 67a, PIL table RAM 66a and similar during backward probability calculations and forward probability calculations in the DEC state and MILDEC state. Consequently the PIL table RAM 66a, external likelihood RAM 67a, and decoding result RAM 64 are each configured by mounting two single-port RAM units with N/2 addresses, and the two RAM units are switched at each division unit length L during use. The input RAM units 51a to 51c comprise dual-port RAM.

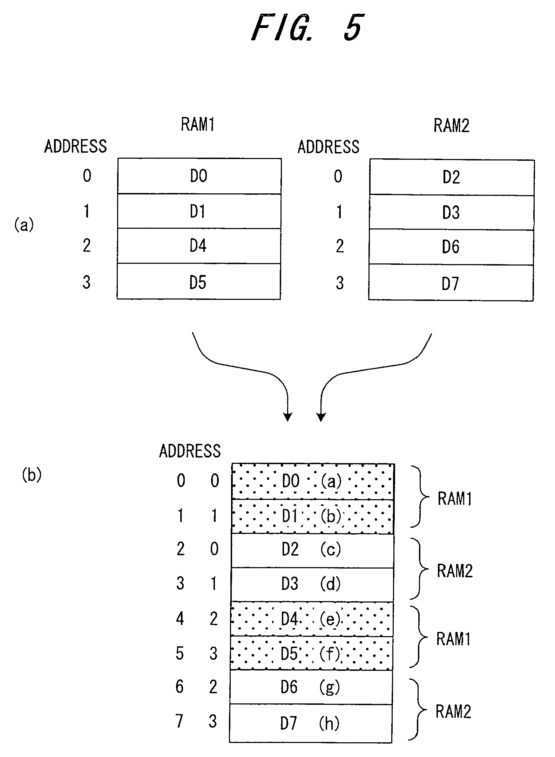

Fig. 5 explains a case in which two single-port RAM units are mounted with N/2 addresses, in an example in which N=8 bits and the division length L = 2 bits. As shown in (a) of Fig. 5, if the two RAM units are RAM1 and RAM2, then the L=2 data D0, D1 is allocated to addresses 0, 1 in RAM1, the data D2, D3 is allocated to addresses 0, 1 in RAM2, the data D4, D5 is allocated to addresses 2, 3 in RAM1, and the data D6, D7 is allocated to addresses 2, 3 in RAM2 (overwriting). Through this configuration, the data in RAM1 and the data in RAM2 can be read and written simultaneously, and the turbo decoder PIL table RAM 66a, decoding result RAM 64, and external likelihood RAM 67a can be accessed simultaneously in backward probability calculations and forward probability calculations. As shown in (b) of Fig. 5, RAM1 and RAM2 are combined and consecutive addresses assigned, and the stored contents are a to h.

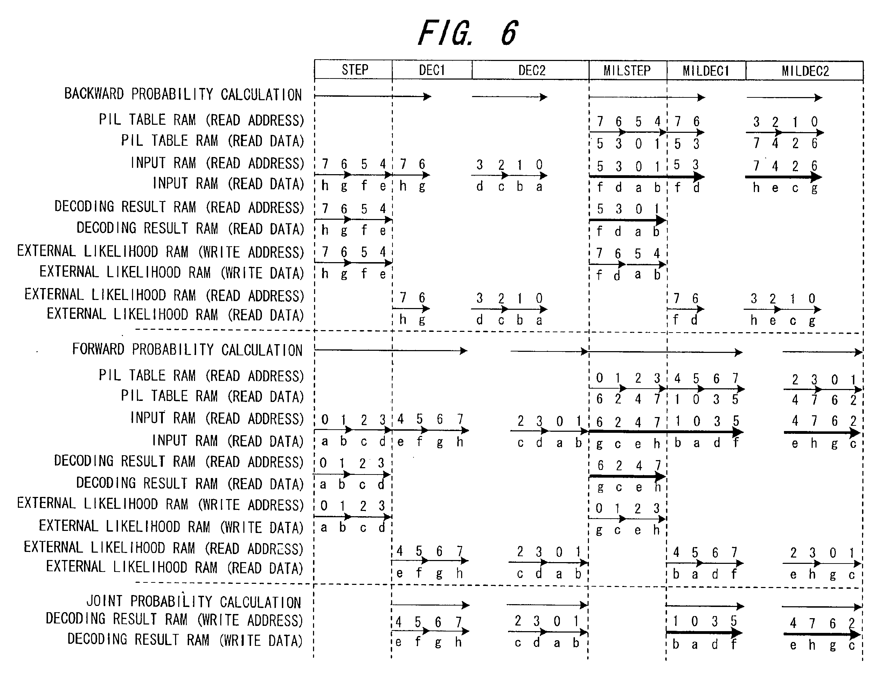

Fig. 6 shows the timing of the turbo decoder in Fig.1; operation is divided into the first half in which interleaving is not performed and the second half in which interleaving is performed, and to facilitate the explanation, it is assumed that N = 8 bits and the division length L = 2 bits. In each of the states of Fig. 6, the input RAM units 51a to 51c, decoding result RAM 64, external likelihood RAM 67a, and PIL table RAM 66a are accessed simultaneously in backward probability calculations and forward probability calculations. In the first half, interleaving is not performed, so that by means of a configuration in which two single-port RAM with N/2 addresses are mounted, simultaneous access is made possible. But in the MILSTEP state and MILDEC state of the second half, reordering is performed based on the PIL pattern, so that simply mounting two single-port RAM units with N/2 addresses is not sufficient.

Hence in Embodiment 2, the external likelihood RAM 67a and PIL table RAM 66a are configured as two single-port RAM units with N/2 addresses which can be accessed simultaneously, but for the input RAM 51a to 51c and the decoding result RAM 64 two banks are mounted, with one used for forward probability calculations and the other used for backward probability calculations. Or, the input RAM 51a to 51c and the decoding result RAM 64 are configured as dual-port RAM, with the A port of the dual-port RAM used for forward probability calculations, and the B port used for backward probability calculations.

An explanation of writing to the external likelihood RAM 67a follows. Because writing is performed simultaneously from the back to addresses (7, 6, 5, 4) and from the front to addresses (0, 1, 2, 3), by configuring the memory as two single-port RAMs, simultaneous writing is made possible.

With respect to the decoding result RAM 64, on the other hand, because in the STEP state the addresses (7, 6, 5, 4) are accessed from the back and the addresses (0, 1, 2, 3) are accessed from the front, by employing two single-port RAM units, simultaneous reading is possible, but because in the MILSTEP state the PIL pattern is used for reading, even in configuration employing two single-port RAM units, the need arises to simultaneously access one single-port RAM unit, so that even when using two single-port RAM units simultaneous access is not possible. Hence either the decoding result RAM 64 must be changed to dual-port RAM, or two banks must be used. When employing dual-port RAM, the A port is used for backward probability calculation and the B port is used for forward probability calculation (or vice-versa), and when employing two RAM banks, in the STEP (MILSTEP) state one is used for backward probability readout and the other is used for forward probability reading, while in the DEC (MILDEC) state, when writing the decoding results, the same data is written to both.

Embodiment 3

If, as in Embodiment 2, two RAM banks are employed, or dual-port RAM is used, there is the problem that the amount of memory employed increases or costs are increased. Hence in Embodiment 3, as the external likelihood RAM 67a, PIL table RAM 66a and decoding result RAM 64, two single-port RAM units with N/2 addresses are mounted. The input RAM units 51a to 51c are dual-port RAM units.

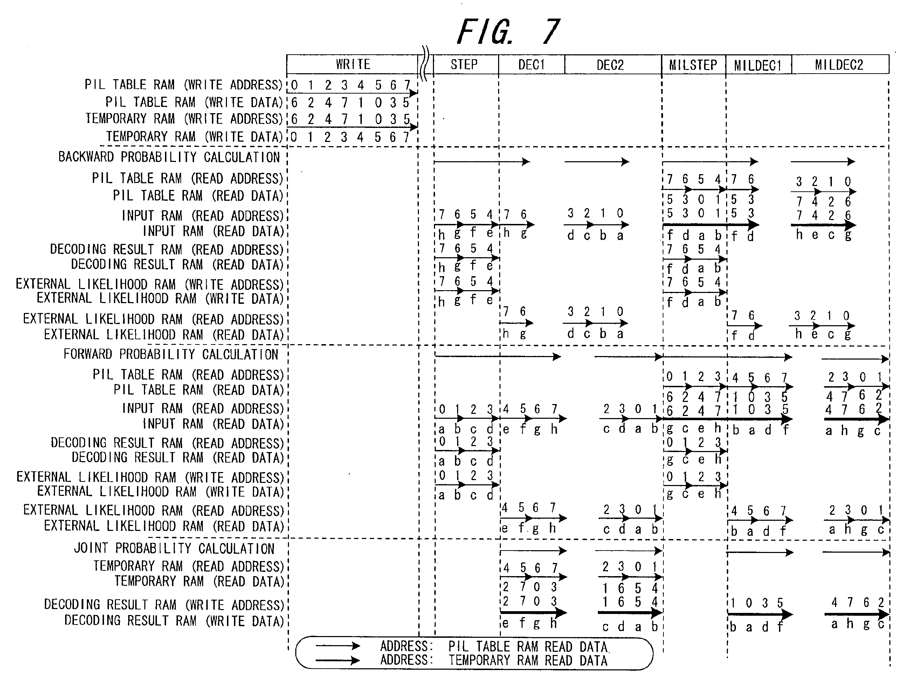

In Embodiment 2, the decoding result RAM 64 could not be configured as two single-port RAM units because the external information likelihood (prior information) was interleaved and stored in the decoding result RAM 64. Hence in Embodiment 3, as indicated by the calculation sequence in Fig. 7 (the DEC1 and DEC2 states), temporary RAM is employed and the external information likelihood is written to the decoding result RAM 64 without interleaving. As a result, in the MILSTEP state, as in the STEP state, reading of the decoding result RAM 64 is performed simultaneously for the addresses (7, 6, 5, 4) from the back and for the addresses (0, 1, 2, 3) from the front, so that simultaneous access is possible even when using two single-port RAM units.

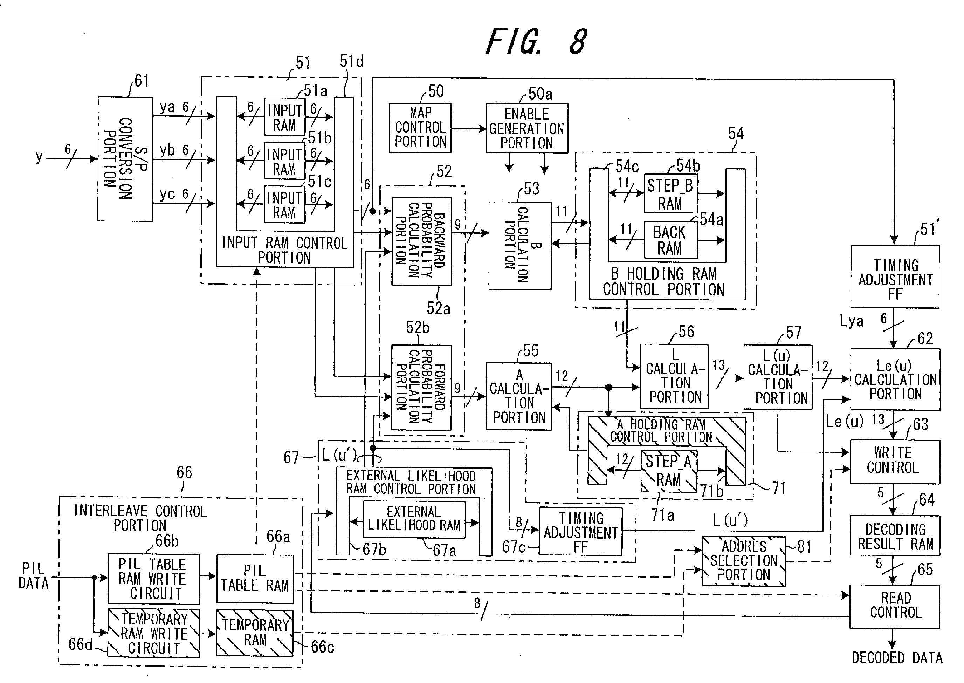

Fig. 8 shows the configuration of the turbo decoder of Embodiment 3. Differences with the first embodiment of Fig. 1 are (1) the provision of temporary RAM 66c within the interleave control portion 66, which stores the reverse pattern of the PIL pattern, and of a temporary RAM write circuit 66d which writes the reverse pattern to the temporary RAM; and, (2) an address selection portion 81 is provided which, in the first-half DEC state, takes addresses output from the temporary RAM 66c to be write addresses for the decoding result RAM 64, and in the second-half MILDEC state, takes addresses generated from the PIL table RAM 66a to be write addresses for the decoding result RAM 64. The reverse pattern read from the temporary RAM returns the addresses of the PIL pattern to the original addresses; as indicated in the upper-left of Fig. 7, the addresses (0, 1, ..., 5, 6, 7) are modified by the PIL pattern to (6, 2, ..., 0, 3, 5), but the reverse pattern returns these to the original addresses (0, 1, ..., 5, 6, 7).

In Embodiment 3, as indicated in the calculation sequence in Fig. 7, the operation in the STEP state is the same as in Embodiment 2, but in the DEC state, when writing the decoding results addresses are read according to the reverse pattern in temporary RAM 66c, and the addresses are used as the write addresses of the decoding result RAM 64 to write to the external information likelihood Le(u). As a result, in the next MILSTEP state it is possible to read the external information likelihoods Le(u) from the decoding result RAM 64 with the addresses (7, 6, 5, 4) from the back and the addresses (0, 1, 2, 3) from the front. In the MILDEC state, the external information likelihoods Le(u) are written taking the addresses according to the PIL pattern read from the PIL table RAM 66a as the write addresses for the decoding result RAM 64. In Embodiment 3, by providing the temporary RAM 66c, there is no longer a need to use two-bank RAM or dual-port RAM as the decoding result RAM 64, and the circuit scale can be reduced.

**Claims**

1. A maximum a posteriori probability decoding method, in which the first to kth encoded data items of encoded data, obtained by encoding information of length N, are used to calculate the kth forward probability, the Nth to kth encoded data items are used to calculate the kth backward probability, and the probabilities are used to output the kth decoding result, comprising:

   a first step, when dividing the information length N into a plurality of sections, of calculating the backward probabilities from the Nth backward probability in the reverse direction to the (n+1)th section and storing the backward probabilities at each division point, and in parallel with the backward probability calculations, of calculating the forward probabilities from the first forward probability in the forward direction to the nth section, and of storing the forward probabilities at each division point;
   a second step, using said stored backward probabilities, of calculating backward probabilities from the (n+1)th section to the final section, of calculating forward probabilities from the (n+1)th section to the final section, and of using the backward probabilities and forward probabilities to calculate the decoding results from the (n+1)th section to the final section; and,
   a third step of using said stored forward probabilities to calculate forward probabilities from the nth section to the first section, of using said stored nth division point backward probabilities to calculate backward probabilities from the nth section to the first section, and of using the forward probabilities and backward probabilities to calculate decoding results from the nth section to the first section.

2. The decoding method according to Claim 1, wherein the total number of said divided sections is 2n or is 2n+1 (where n is a natural number), and the backward probability for said (n+1)th section is stored when the backward probabilities are calculated from said Nth backward probability, in reverse direction, to the (n+1)th section.

3. The decoding method according to Claim 1, wherein
   said first step comprises a step of calculating backward probabilities from the Nth backward probability in the reverse direction to the (n+1)th section, and of storing, as discrete values, backward probabilities at each division point, as well as continuously storing the backward probabilities of the (n+1)th division section, and a step, in parallel with the backward probabilities calculations, of calculating forward probabilities from the first forward probability, in the forward direction, to the nth section, and of storing, as discrete values, the forward probabilities for each division point;
   said second step comprises a step of calculating the forward probability for the (n+1)th division section, using the forward probabilities and said stored backward probability for the (n+1)th division section to calculate the decoding result for the (n+1)th division section, and in parallel with these calculations, calculating the backward probability of the (n+2)th division section, in reverse direction, from the backward probabilities of the stored (n+2) division point, and a step of calculating the forward probability for the (n+2)th division section, using the forward probabilities and said stored backward probability for the (n+2)th division section to calculate the decoding result for the (n+2)th division section, and, in parallel with these calculations, of calculating the backward probability of the (n+3)th division section in reverse direction from said stored backward probability at division point (n+3), and subsequently similarly calculating decoding results up to the final division section; and,
   said third step comprises a step of calculating the backward probability of the nth division section in reverse direction from the stored backward probability of said division point n, a step of calculating the forward probability of the nth division section using said stored forward probability of the (n-1)th division point, of calculating the decoding result of the nth division section using the forward probability and the stored backward probability for the nth division section, and, in parallel with these calculations, of calculating the backward probability, in reverse direction, of the (n-1)th division section, and a step of using the stored forward probability for the (n-2)th division point to calculate the forward probability for the (n-1)th division section, of using the forward probability and the stored backward probability for the (n-1)th division section to calculate the decoding result for the (n-1)th division section, and in parallel with these calculations, of calculating and storing the backward probability for the (n-2)th division section in reverse direction, and subsequently of similarly calculating the decoding results up to the final division section.

4. The decoding method according to Claim 3, wherein, when said division number is odd, in said first step the (2n+1) th division section backward probability is calculated first in reverse direction from the Nth backward probability, then, backward probabilities are calculated from the 2nth division section to the (n+1)th division section and simultaneously forward probabilities are calculated from the first division section to the nth division section.

5. The decoding method according to Claim 3, wherein, when said division number is even, in said first step, after the end of calculation of the forward probability of the first division section and calculation of the backward probability of the 2nth division section, the backward probabilities from the (2n-1)th division section to the (n+1)th division section and the forward probabilities from the second division section to the nth division section are calculated in parallel.

6. The decoding method according to Claim 3, wherein memory accessed simultaneously during forward probability calculations and backward probability calculations is configured as two single-port RAM units the minimum number of addresses of which is N/2, and with addresses generated such that a single-port RAM unit is not accessed simultaneously, and, when addresses cannot be generated such that said single-port RAM units are not accessed simultaneously, a configuration is employed using dual-port RAM as said memory, or using memory with two banks.

7. The decoding method according to Claim 3, wherein memory accessed simultaneously during forward probability calculations and backward probability calculations is configured as two single-port RAM units the minimum number of addresses of which is N/2, and with addresses generated such that a single-port RAM unit is not accessed simultaneously, and, when due to interleave processing said single-port RAM units are accessed simultaneously, addresses are generated so as not to access single-port RAM simultaneously by returning interleave-processed addresses to the original addresses and storing data in said memory.

8. A decoding apparatus, in which the first to kth encoded data items of encoded data, obtained by encoding information of length N, are used to calculate the kth forward probability, the Nth to kth encoded data items are used to calculate the kth backward probability, and the probabilities are used to output the kth decoding result, comprising:

   a backward probability calculation portion for calculating backward probabilities;
   a backward probability storage portion for storing calculated backward probabilities;
   a forward probability calculation portion for calculating forward probabilities;
   a forward probability storage portion for storing calculated forward probabilities;
   a decoding result calculation portion for using the kth forward probability and the kth backward probability to calculate the kth decoding result; and,
   a control portion for controlling the calculation timing of said backward probability calculation portion, forward probability calculation portion, and decoding result calculation portion, wherein

   (a) when dividing an information length N by division lengths L, such that the number of divisions including the remainder is 2n (where 2n is an even number) or 2n+1 (where 2n+1 is an odd number), said backward probability calculation portion calculates the backward probabilities in the reverse direction from the Nth backward probability to the (n+1)th section and stores the backward probabilities at each division point as discrete values in said backward probability storage portion, and in parallel with the backward probability calculations, said forward probability calculation portion calculates the forward probabilities from the first forward probability in the forward direction to the nth section and stores the forward probabilities at each division point as discrete values in said forward probability storage portion;
   (b) said backward probability calculation portion calculates the backward probabilities from the (n+1)th section to the final section using said stored discrete values of backward probabilities, said forward probability calculation portion calculates forward probabilities from the (n+1)th section to the final section, and said decoding result calculation portion uses these backward probabilities and forward probabilities to calculate decoding results from the (n+1)th section to the final section; and,
   (c) said forward probability calculation portion uses said stored discrete values of forward probabilities to calculate the forward probabilities from the nth section to the first section, said backward probability calculation portion uses said stored backward probability at the nth division point to calculate the backward probabilities from the nth section to the first section, and said decoding result calculation portion uses these forward probabilities and backward probabilities to calculate the decoding results from the nth section to the first section.

9. The decoding apparatus according to Claim 8, wherein, upon calculating the backward probabilities from said Nth backward probability to the (n+1)th section in the reverse direction, the backward probability for said (n+1)th section is stored in said backward probability storage portion.

EP 1 724 934 A1

# FIG. 1

S/P CONVERSION PORTION — 61

INPUT RAM CONTROL PORTION — 51
- INPUT RAM — 51a
- INPUT RAM — 51b
- INPUT RAM — 51c
- 51d

MAP CONTROL PORTION — 50

ENABLE GENERATION PORTION — 50a

BACKWARD PROBABILITY CALCULATION PORTION — 52 / 52a

FORWARD PROBABILITY CALCULATION PORTION — 52b

B CALCULATION PORTION — 53

B HOLDING RAM CONTROL PORTION — 54
- STEP_B RAM — 54b
- 54c
- BACK RAM — 54a

A CALCULATION PORTION — 55

A HOLDING RAM CONTROL PORTION
- STEP_A RAM — 71b
- 71a

L CALCULATION PORTION — 56

L(u) CALCULATION PORTION — 57

TIMING ADJUSTMENT FF — 51'

Le(u) CALCULATION PORTION — 62

WRITE CONTROL — 63

DECODING RESULT RAM — 64

READ CONTROL — 65

EXTERNAL LIKELIHOOD RAM CONTROL PORTION — 67
- EXTERNAL LIKELIHOOD RAM — 67a
- 67b
- TIMING ADJUSTMENT FF — 67c

INTERLEAVE CONTROL PORTION — 66
- PIL TABLE RAM WRITE CIRCUIT — 66a
- PIL TABLE RAM — 66a

Inputs/labels: y, ya, yb, yc, PIL DATA, L(u'), Lya, Le(u), L(u'), DECODED DATA

Signal widths: 6, 9, 11, 12, 13, 8, 5

# FIG. 2

| STEP | DEC1 | DEC2 |
|------|------|------|

BACKWARD PROBABILITY CALCULATION

N    6L    5L    4L    3L 5L   4L 6L   5L N   6L     3L    2L    L    1

B MEMORY

WRITE   WRITE     WRITE READ   READ         READ

FORWARD PROBABILITY CALCULATION

1    L    2L   3L     4L    5L    6L    N     2L   3L L   2L 1    L

A MEMORY

WRITE   WRITE               READ   READ

JOINT PROBABILITY CALCULATION

3L   4L    5L    6L    N     2L   3L L   2L 1    L

EP 1 724 934 A1

FIG. 3

# FIG. 4

```
                          START

                                        101
         EVEN       IS THE NUMBER OF
              ╱  DIVISIONS EVEN OR ODD ?  ╲
                            ODD

                                        102
                   PERFORM TURBO DECODING
                 ACCORDING TO THE CALCULATION
                    SEQUENCE OF FIG.  2

                103
       PERFORM TURBO DECODING
     ACCORDING TO THE CALCULATION
        SEQUENCE OF FIG.  3

                           END
```

# FIG. 5

FIG. 6

EP 1 724 934 A1

# FIG. 7

EP 1 724 934 A1

| | WRITE | STEP | DEC1 | DEC2 | MILSTEP | MILDEC1 | MILDEC2 |
|---|---|---|---|---|---|---|---|
| PIL TABLE RAM (WRITE ADDRESS) | 0 1 2 3 4 5 6 7 | | | | | | |
| PIL TABLE RAM (WRITE DATA) | 6 2 4 7 1 0 3 5 | | | | | | |
| TEMPORARY RAM (WRITE ADDRESS) | 6 2 4 7 1 0 3 5 | | | | | | |
| TEMPORARY RAM (WRITE DATA) | 0 1 2 3 4 5 6 7 | | | | | | |
| BACKWARD PROBABILITY CALCULATION | | | | | | | |
| PIL TABLE RAM (READ ADDRESS) | | | | | 7 6 5 4 | 7 6 | 3 2 1 0 |
| PIL TABLE RAM (READ DATA) | | | | | 5 3 0 1 | 5 3 | 7 4 2 6 |
| INPUT RAM (READ ADDRESS) | | 7 6 5 4 | 7 6 | 3 2 1 0 | 5 3 0 1 | 5 3 | 7 4 2 6 |
| INPUT RAM (READ DATA) | | h g f e | h g | d c b a | f d a b | f d | h e c g |
| DECODING RESULT RAM (READ ADDRESS) | | 7 6 5 4 | | | 7 6 5 4 | | |
| DECODING RESULT RAM (READ DATA) | | h g f e | | | f d a b | | |
| EXTERNAL LIKELIHOOD RAM (WRITE ADDRESS) | | 7 6 5 4 | | | 7 6 5 4 | | |
| EXTERNAL LIKELIHOOD RAM (WRITE DATA) | | h g f e | | | f d a b | | |
| EXTERNAL LIKELIHOOD RAM (READ ADDRESS) | | | 7 6 | 3 2 1 0 | | 7 6 | 3 2 1 0 |
| EXTERNAL LIKELIHOOD RAM (READ DATA) | | | h g | d c b a | | f d | h e c g |
| FORWARD PROBABILITY CALCULATION | | | | | | | |
| PIL TABLE RAM (READ ADDRESS) | | | | | 0 1 2 3 | 4 5 6 7 | 2 3 0 1 |
| PIL TABLE RAM (READ DATA) | | | | | 6 2 4 7 | 1 0 3 5 | 4 7 6 2 |
| INPUT RAM (READ ADDRESS) | | 0 1 2 3 | 4 5 6 7 | 2 3 0 1 | 6 2 4 7 | 1 0 3 5 | 4 7 6 2 |
| INPUT RAM (READ DATA) | | a b c d | e f g h | c d a b | g c e h | b a d f | a h g c |
| DECODING RESULT RAM (READ ADDRESS) | | 0 1 2 3 | | | 0 1 2 3 | | |
| DECODING RESULT RAM (READ DATA) | | a b c d | | | g c e h | | |
| EXTERNAL LIKELIHOOD RAM (WRITE ADDRESS) | | 0 1 2 3 | | | 0 1 2 3 | | |
| EXTERNAL LIKELIHOOD RAM (WRITE DATA) | | a b c d | | | g c e h | | |
| EXTERNAL LIKELIHOOD RAM (READ ADDRESS) | | | 4 5 6 7 | 2 3 0 1 | | 4 5 6 7 | 2 3 0 1 |
| EXTERNAL LIKELIHOOD RAM (READ DATA) | | | e f g h | c d a b | | b a d f | a h g c |
| JOINT PROBABILITY CALCULATION | | | | | | | |
| TEMPORARY RAM (READ ADDRESS) | | | 4 5 6 7 | 2 3 0 1 | | | |
| TEMPORARY RAM (READ DATA) | | | 2 7 0 3 | 1 6 5 4 | | | |
| DECODING RESULT RAM (WRITE ADDRESS) | | | 2 7 0 3 | 1 6 5 4 | | 1 0 3 5 | 4 7 6 2 |
| DECODING RESULT RAM (WRITE DATA) | | | e f g h | c d a b | | b a d f | a h g c |

⟶ ADDRESS: PIL TABLE RAM READ DATA
⟹ ADDRESS: TEMPORARY RAM READ DATA

# FIG. 8

# FIG. 9 PRIOR ART

# FIG. 10   PRIOR ART

# FIG. 11   PRIOR ART

*FIG. 12 PRIOR ART*

# FIG. 13 PRIOR ART

$Y_{ak}$

$Y_{bk}$

1 TRANSITION PROBABILITY CALCULATION PORTION

$\gamma_{0,k} \sim \gamma_{3,k}$

3 FORWARD PROBABILITY CALCULATION PORTION

$\alpha_{1,k}$

$\alpha_{0,k}$

$\alpha_{0,k-1}$

$\alpha_{1,k-1}$

DELAY

DELAY

STATE

STATE

$\alpha_{1,k}(3)$  $\alpha_{0,k}(3)$

| $\alpha_{1,k}(0)$ ("1" PROBABILITY) | $\alpha_{0,k}(0)$ ("0" PROBABILITY) | |
|---|---|---|
| $\alpha_{1,1}$ | $\alpha_{0,1}$ | |
| $\alpha_{1,2}$ | $\alpha_{0,2}$ | |
| $\vdots$ | $\vdots$ | $\vdots$ |
| $\alpha_{1,N}$ | $\alpha_{0,N}$ | |

4a

4d

2

| $\gamma_{0,k}$ (0,0) | $\gamma_{1,k}$ (0,1) | $\gamma_{2,k}$ (1,0) | $\gamma_{3,k}$ (1,1) |
|---|---|---|---|
| $\gamma_{0,1}$ | $\gamma_{1,1}$ | $\gamma_{2,1}$ | $\gamma_{3,1}$ |
| $\gamma_{0,2}$ | $\gamma_{1,2}$ | $\gamma_{2,1}$ | $\gamma_{3,1}$ |
| $\vdots$ | $\vdots$ | $\vdots$ | $\vdots$ |
| $\gamma_{0,N}$ | $\gamma_{1,N}$ | $\gamma_{2,N}$ | $\gamma_{3,N}$ |

$\gamma_{0,k+1} \sim \gamma_{3,k+1}$

5 BACKWARD PROBABILITY CALCULATION PORTION

$\beta_k(m)$

DELAY

$\beta_{k+1}$

$\alpha_{0,k}(m)$

$\alpha_{1,k}(m)$

1 JOINT PROBABILITY CALCULATION

6a

$\lambda_{1,k}(m)$

0 JOINT PROBABILITY CALCULATION

6b

$\lambda_{0,k}(m)$

6

7 $u_k$ AND $u_k$ LIKELIHOOD CALCULATION PORTION

$L(u_k)$

$u_k$

EP 1 724 934 A1

## FIG. 14 PRIOR ART

## FIG. 15 PRIOR ART

## FIG. 16 PRIOR ART

(1) · FIRST BACKWARD PROBABILITY CALCULATION
· BACKWARD PROBABILITY CALCULATION HELD

(2) · FIRST FORWARD PROBABILITY CALCULATION
· $u_k$ AND $u_k$ LIKELIHOOD CALCULATION

(3) · SECOND BACKWARD PROBABILITY CALCULATION
· BACKWARD PROBABILITY CALCULATION HELD

(4) · SECOND FORWARD PROBABILITY CALCULATION
· $u_k$ AND $u_k$ LIKELIHOOD CALCULATION

(5) · THIRD BACKWARD PROBABILITY CALCULATION
· BACKWARD PROBABILITY CALCULATION HELD

(6) · THIRD FORWARD PROBABILITY CALCULATION
· $u_k$ AND $u_k$ LIKELIHOOD CALCULATION

EP 1 724 934 A1

# FIG. 17 PRIOR ART

| STEP | DEC |
|---|---|

BACKWARD PROBABILITY CALCULATION

N   6L   5L   4L   3L   2L   L   0   2L   L 3L   2L 4L   3L 5L   4L 6L   5L N   6L

MEMORY 54

WRITE WRITE  WRITE  WRITE WRITE     READ READ   READ   READ   READ

FORWARD PROBABILITY CALCULATION

0   L   2L   3L   4L   5L   6L   N

JOINT PROBABILITY CALCULATION

0   L   2L   3L   4L   5L   6L   N

(1)   (2)   (3)   (4)   (5)   (6)   (7)   (8)

EP 1 724 934 A1

*FIG. 18 PRIOR ART*

ya →
yb →
51 INPUT/OUTPUT SWITCHING PORTION
52 TRANSITION PROBABILITY CALCULATION PORTION
55 FORWARD PROBABILITY CALCULATION PORTION
53 BACKWARD PROBABILITY CALCULATION PORTION
54 MEMORY
56 JOINT PROBABILITY CALCULATION PORTION
57 $u_k$ AND $u_k$ LIKELIHOOD CALCULATION PORTION
$u_k$
$L(u_k)$
50 MAP CONTROL PORTION

54
$\beta_{ms}(m)$
$\beta_{m(s-1)}(m)$
...
$\beta_{m3}(m)$
$\beta_{m2}(m)$
54a

$\beta_{m1}(m)$
$\gtrless$
$\beta_1(m)$
54b

EP 1 724 934 A1

FIG. 19 PRIOR ART

FIG. 20 PRIOR ART

# FIG. 21 PRIOR ART

| | STEP | DEC | MILSTEP | MILDEC |
|---|---|---|---|---|
| BACKWARD PROBABILITY CALCULATION | → | → | → | → |
| PIL TABLE RAM (READ ADDRESS) | | | 7 6 5 4 3 2 1 0 | 3 2 5 4 7 6 |
| PIL TABLE RAM (READ DATA) | | | 5 3 0 1 7 4 2 6 | 7 4 0 1 5 3 |
| INPUT RAM (READ ADDRESS) | 7 6 5 4 3 2 1 0 | 3 2 5 4 7 6 | 5 3 0 1 7 4 2 6 | 7 4 0 1 5 3 |
| INPUT RAM (READ DATA) | h g f e d c b a | d c f e h g | f d a b h e c g | h e a b f d |
| DECODING RESULT RAM (READ ADDRESS) | 7 6 5 4 3 2 1 0 | | 5 3 0 1 7 4 2 6 | |
| DECODING RESULT RAM (READ DATA) | h g f e d c b a | | f d a b h e c g | |
| EXTERNAL LIKELIHOOD RAM (WRITE ADDRESS) | 7 6 5 4 3 2 1 0 | | 7 6 5 4 3 2 1 0 | |
| EXTERNAL LIKELIHOOD RAM (WRITE DATA) | h g f e d c b a | | f d a b h e c g | |
| EXTERNAL LIKELIHOOD RAM (READ ADDRESS) | | 3 2 5 4 7 6 | | 3 2 5 4 7 6 |
| EXTERNAL LIKELIHOOD RAM (READ DATA) | | d c f e h g | | d c f e h g |
| FORWARD PROBABILITY CALCULATION | | → | | → |
| PIL TABLE RAM (READ ADDRESS) | | | | 0 1 2 3 4 5 6 7 |
| PIL TABLE RAM (READ DATA) | | | | 6 2 4 7 1 0 3 5 |
| INPUT RAM (READ ADDRESS) | | 0 1 2 3 4 5 6 7 | | 6 2 4 7 1 0 3 5 |
| INPUT RAM (READ DATA) | | a b c d e f g h | | g c e h b a d f |
| DECODING RESULT RAM (READ ADDRESS) | | | | |
| DECODING RESULT RAM (READ DATA) | | | | |
| EXTERNAL LIKELIHOOD RAM (WRITE ADDRESS) | | | | |
| EXTERNAL LIKELIHOOD RAM (WRITE DATA) | | | | |
| EXTERNAL LIKELIHOOD RAM (READ ADDRESS) | | 0 1 2 3 4 5 6 7 | | C 1 2 3 4 5 6 7 |
| EXTERNAL LIKELIHOOD RAM (READ DATA) | | a b c d e f g h | | g c e h b a d f |
| JOINT PROBABILITY CALCULATION | | → | | → |
| DECODING RESULT RAM (WRITE ADDRESS) | | 0 1 2 3 4 5 6 7 | | 6 2 4 7 1 0 3 5 |
| DECODING RESULT RAM (WRITE DATA) | | a b c d e f g h | | g c e h b a d f |

EP 1 724 934 A1

European Patent
Office

**EUROPEAN SEARCH REPORT**

Application Number

EP 05 25 5960

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 367 732 A (BROADCOM CORPORATION) 3 December 2003 (2003-12-03) * figure 13 * * paragraph [0134] - paragraph [0145] * * paragraph [0064] - paragraph [0066] * ----- | 1-9 | H03M13/29 H03M13/45 |
| A | ZHONGFENG WANG ET AL: "Area-efficient high speed decoding schemes for turbo/MAP decoders" 2001 IEEE INTERNATIONAL CONFERENCE ON ACOUSTICS, SPEECH, AND SIGNAL PROCESSING. PROCEEDINGS. (ICASSP). SALT LAKE CITY, UT, MAY 7 - 11, 2001, IEEE INTERNATIONAL CONFERENCE ON ACOUSTICS, SPEECH, AND SIGNAL PROCESSING (ICASSP), NEW YORK, NY : IEEE, US, vol. VOL. 1 OF 6, 7 May 2001 (2001-05-07), pages 2633-2636, XP010803224 ISBN: 0-7803-7041-4 * the whole document * ----- | 1-9 | |
| A | YUPING ZHANG ET AL: "Parallel turbo decoding" CIRCUITS AND SYSTEMS, 2004. ISCAS '04. PROCEEDINGS OF THE 2004 INTERNATIONAL SYMPOSIUM ON VANCOUVER, BC, CANADA 23-26 MAY 2004, PISCATAWAY, NJ, USA,IEEE, US, 23 May 2004 (2004-05-23), pages 509-512, XP010720217 ISBN: 0-7803-8251-X * figures 3-7 * ----- | 1-9 | **TECHNICAL FIELDS SEARCHED (IPC)** H03M |
| A | EP 1 391 995 A (NEC ELECTRONICS CORPORATION) 25 February 2004 (2004-02-25) * figure 23 * ----- -/-- | 1-9 | |

The present search report has been drawn up for all claims

| Place of search | Date of completion of the search | Examiner |
|---|---|---|
| The Hague | 25 January 2006 | Rydyger, K |

EPO FORM 1503 03.82 (P04C01)

**European Patent Office**

**EUROPEAN SEARCH REPORT**

Application Number

EP 05 25 5960

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | EP 1 156 588 A (FUJITSU LIMITED) 21 November 2001 (2001-11-21) * figure 7 * * the whole document * | 1-9 | |
| A,P | US 2005/172204 A1 (LIN HUA) 4 August 2005 (2005-08-04) * figures 1,5 * | 1-9 | |
| A | EP 1 521 374 A (FUJITSU LIMITED) 6 April 2005 (2005-04-06) * the whole document * * figures 5,6 * | 1-9 | |
| A | BOUTILLON E ET AL: "VLSI ARCHITECTURES FOR THE MAP ALGORITHM" IEEE TRANSACTIONS ON COMMUNICATIONS, IEEE SERVICE CENTER, PISCATAWAY, NJ, US, vol. 51, no. 2, February 2003 (2003-02), pages 175-185, XP001164390 ISSN: 0090-6778 * figures 5,6 * | 1-9 | TECHNICAL FIELDS SEARCHED (IPC) |
| A | US 6 192 501 B1 (HLADIK STEPHEN MICHAEL ET AL) 20 February 2001 (2001-02-20) * figure 4 * | 1-9 | |

The present search report has been drawn up for all claims

| Place of search | Date of completion of the search | Examiner |
|---|---|---|
| The Hague | 25 January 2006 | Rydyger, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

**ANNEX TO THE EUROPEAN SEARCH REPORT
ON EUROPEAN PATENT APPLICATION NO.**

EP 05 25 5960

This annex lists the patent family members relating to the patent documents cited in the above-mentioned European search report.
The members are as contained in the European Patent Office EDP file on
The European Patent Office is in no way liable for these particulars which are merely given for the purpose of information.

25-01-2006

| Patent document cited in search report | | | Publication date | Patent family member(s) | | Publication date |
|---|---|---|---|---|---|---|
| EP 1367732 | A | | 03-12-2003 | NONE | | |
| EP 1391995 | A | | 25-02-2004 | CN | 1489294 A | 14-04-2004 |
| | | | | JP | 2004080508 A | 11-03-2004 |
| | | | | US | 2004039769 A1 | 26-02-2004 |
| EP 1156588 | A | | 21-11-2001 | CN | 1336038 A | 13-02-2002 |
| | | | | WO | 0052833 A1 | 08-09-2000 |
| | | | | JP | 3451246 B2 | 29-09-2003 |
| | | | | US | 2002015457 A1 | 07-02-2002 |
| US 2005172204 | A1 | | 04-08-2005 | CN | 1645751 A | 27-07-2005 |
| | | | | EP | 1564893 A1 | 17-08-2005 |
| | | | | JP | 2005210238 A | 04-08-2005 |
| EP 1521374 | A | | 06-04-2005 | JP | 2005109771 A | 21-04-2005 |
| | | | | US | 2005149836 A1 | 07-07-2005 |
| US 6192501 | B1 | | 20-02-2001 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5446747 A

- WO 0052833 A